# EUROPEAN PATENT APPLICATION

(11) **EP 4 801 106 A1**
(43) Date of publication of application: **02.09.2026**
(21) Application number: 24888020.5
(22) Date of filing: 06.11.2024
(51) Int. Cl.: H04W 28/06

(54) **DATA COMPRESSION METHOD, APPARATUS AND SYSTEM, DATA DECOMPRESSION METHOD, APPARATUS AND SYSTEM, MEDIUM AND PROGRAM PRODUCT**

(30) Priority: 10.11.2023 CN 202311507445
(71) Applicant: Huawei Technologies Co., Ltd., Shenzhen, Guangdong 518129 (CN)
(72) Inventor: DU, Yuqing, Shenzhen, Guangdong 518129 (CN); MA, Mengyao, Shenzhen, Guangdong 518129 (CN)
(74) Representative: Maiwald GmbH
(86) International application number: PCT/CN2024/130330
(87) International publication number: WO 2025/098409

(57) **Abstract**

Embodiments of this application provide a data compression or data decompression method, an apparatus, a system, a medium, and a program product. In the method, a compression device obtains codebook splitting information, where the codebook splitting information indicates to split an overall codebook into a plurality of sub-codebooks. For an original sequence obtained based on the overall codebook, the compression device obtains a first-level sequence and a second-level sequence, where the first-level sequence includes a number of a sub-codebook, among the plurality of sub-codebooks, to which each element in the original sequence belongs, and the second-level sequence includes a position of the element in the sub-codebook to which the element belongs. In addition, the compression device sends a compressed sequence obtained based on the first-level sequence and the second-level sequence. In this way, when data is sent in a data communication process, to-be-sent data can be compressed more effectively, and an amount of resources required for sending the data is reduced.

## Description

This application claims priority to Chinese Patent Application No. 202311507445.4, filed with the China National Intellectual Property Administration on November 10, 2023 and entitled "DATA COMPRESSION AND DECOMPRESSION METHOD, APPARATUS, SYSTEM, MEDIUM, AND PROGRAM PRODUCT", which is incorporated herein by reference in its entirety.

### TECHNICAL FIELD

This application relates to the communication field, and more specifically, to a data compression or data decompression method, an apparatus, a system, a computer-readable storage medium, and a computer program product in the communication field.

### BACKGROUND

In data communication scenarios, users typically compress a large amount of data and before transmitting them to a cloud. In other technical scenarios, data compression also frequently required. Generally, compression is used to reduce an amount of data to be stored or transmitted. However, there is still room for further optimization and improvement of data compression or decompression technologies.

### SUMMARY

In general, example embodiments of this application provide a data compression or data decompression method, apparatus, and system, a computer-readable storage medium, and a computer program product.

According to a first aspect of this application, a method is provided. The method includes: obtaining codebook splitting information, where the codebook splitting information indicates to split an overall codebook into a plurality of sub-codebooks; obtaining a first-level sequence and a second-level sequence for an original sequence obtained based on the overall codebook, where the first-level sequence includes a number of a sub-codebook, among the plurality of sub-codebooks, to which each element in the original sequence belongs, and the second-level sequence includes a position of the element in the sub-codebook to which the element belongs; and sending a compressed sequence obtained based on the first-level sequence and the second-level sequence. In this way, compared with a compressed sequence obtained based on the original sequence, a data amount of the compressed sequence obtained based on the first-level sequence and the second-level sequence determined from the original sequence can be further reduced, so that an amount of resources required for data transmission can be effectively reduced.

In some implementations, the method may further include: determining, based on the first-level sequence and the second-level sequence, a to-be-transmitted sequence corresponding to the original sequence, where the compressed sequence is obtained based on the to-be-transmitted sequence. In this way, after the original sequence is hierarchized into the first-level sequence and the second-level sequence, some sequences among hierarchized sequences may be sent, thereby improving data transmission efficiency.

In some implementations, the to-be-transmitted sequence is obtained based on a multi-layer sequence, the first-level sequence is a first-level sequence at layer 1 in the multi-layer sequence, the second-level sequence is a second-level sequence at layer 1 in the multi-layer sequence, the sub-codebook is a layer-1 sub-codebook, and the multi-layer sequence is generated in the following manner: determining a to-be-hierarchized sequence among sequences at layer 1; obtaining a first-level sequence at layer 2 and a second-level sequence at layer 2 based on the to-be-hierarchized sequence at layer 1, where the first-level sequence at layer 2 includes a number of a layer-2 sub-codebook, among the plurality of sub-codebooks, to which each element in the to-be-hierarchized sequence at layer 1 belongs, and the second-level sequence at layer 2 includes a position of the element in the layer-2 sub-codebook to which the element belongs. In this way, the original sequence can be hierarchized into a plurality of layers of first-level sequences and second-level sequences, and hierarchization at each layer can further compress the original sequence, thereby further improving data compression efficiency.

In some implementations, the to-be-transmitted sequence may include the first-level sequence and the second-level sequence, and the compressed sequence is obtained in the following manners: separately performing entropy encoding on the first-level sequence and the second-level sequence; or performing entropy encoding on the first-level sequence and the second-level sequence together. In this way, entropy encoding efficiency of data can be improved.

In some implementations, determining the to-be-transmitted sequence may include: determining, as the to-be-transmitted sequence, at least one of the first-level sequence and the second-level sequence in the multi-layer sequence that are determined as not belonging to the to-be-hierarchized sequence, where the compressed sequence is obtained in the following manners: separately performing entropy encoding on the first-level sequence and the second-level sequence in the to-be-transmitted sequence; or performing entropy encoding on the first-level sequence and the second-level sequence in the to-be-transmitted sequence together. In this way, the multi-layer sequence can be compressed more effectively through entropy encoding.

In some implementations, performing entropy encoding on the second-level sequence may include: separately performing entropy encoding on a plurality of sequences in the second-level sequence that belong to different sub-codebooks. In this way, compression efficiency of the second-level sequence can be further improved.

In some implementations, sending the compressed sequence may further include: sending sequence information associated with the to-be-transmitted sequence, where the sequence information includes: sequence length information, indicating a sequence length of the to-be-transmitted sequence. In this way, a data transmission receiving apparatus can effectively restore data in each sequence based on length information of the sequence.

In some implementations, when the to-be-transmitted sequence is obtained based on the multi-layer sequence, the sequence information may further include: sequence position information, indicating a layer at which a sequence in the to-be-transmitted sequence is located, a position of the sequence at the layer, and a position of a corresponding upper-layer sequence at an upper layer. In this way, the data transmission receiving apparatus can further restore the corresponding upper-layer sequence level by level based on sequence position information of each hierarchized sequence, to accurately restore the original sequence.

In some implementations, the sequence information may further include: sequence symbol indication information, indicating whether the sequence in the to-be-transmitted sequence is a first-level sequence or a second-level sequence. In this way, the data transmission receiving apparatus can effectively distinguish between the first-level sequence and the second-level sequence, and restore the upper-layer sequence level by level based on a corresponding sub-codebook, to accurately restore the original sequence.

In some implementations, sending the compressed sequence may include: sending the compressed sequence through a plurality of transmissions, where one of the plurality of transmissions may include: determining, based on an amount of resources allocated for a current transmission, a part of the to-be-transmitted sequence to be sent in the current transmission; and sending a part that is of the compressed sequence and that is obtained based on the part of the to-be-transmitted sequence. In this way, even if the amount of allocated resources in a data transmission process is insufficient, the sequence does not need to be further compressed to a data amount that can be sent at a time by using the amount of allocated resources. Instead, the sequence may be transmitted through a plurality of transmissions. This avoids an unnecessary data loss caused by excessive compression.

In some implementations, the part of the to-be-transmitted sequence includes: a part of the first-level sequence in an unsent part of the first-level sequence in the to-be-transmitted sequence and a part of the second-level sequence in an unsent part of the second-level sequence in the to-be-transmitted sequence, where an element in the part of the first-level sequence corresponds to an element in the part of the second-level sequence; and an amount of resources required for sending the part of the first-level sequence and the part of the second-level sequence is less than the amount of allocated resources. In this way, only a part of the first-level sequence and a part of the second-level sequence that correspond to each other may be transmitted in each transmission process, so that the data transmission receiving apparatus can restore a part of the original sequence based on the part of the first-level sequence and the part of the second-level sequence that correspond to each other without waiting for receiving all sequences, thereby improving data processing efficiency at the receiving apparatus.

In some implementations, sending the part that is of the compressed sequence and that is obtained based on the part of the to-be-transmitted sequence further includes: sending sequence information associated with the part of the to-be-transmitted sequence, where the sequence information associated with the part of the to-be-transmitted sequence includes sequence symbol indication information indicating whether a sequence to which the part of the to-be-transmitted sequence belongs is a first-level sequence or a second-level sequence. In this way, the data transmission receiving apparatus can effectively determine whether each received part of the sequence belongs to the first-level sequence or the second-level sequence, and accurately restore a corresponding part of the original sequence.

In some implementations, when the to-be-transmitted sequence is obtained based on the multi-layer sequence, the sequence information associated with the part of the to-be-transmitted sequence may further include sequence position information of the sequence to which the part of the to-be-transmitted sequence belongs. In this way, the data transmission receiving apparatus can effectively determine a position of each received part of the sequence, and therefore, restore an upper-layer sequence level by level based on a sub-codebook corresponding to the received part of the sequence, so that the corresponding part of the original sequence can be accurately restored.

In some implementations, determining the part of the to-be-transmitted sequence to be sent in the current transmission may include: determining whether an unsent first-type sequence exists, where the first-type sequence includes a first-level sequence or a second-level sequence; and based on determining that the unsent first-type sequence exists: determining whether the amount of resources allocated for the current transmission is sufficient to send the unsent first-type sequence, and in response to the amount of resources allocated for the current transmission being insufficient to send the unsent first-type sequence, selecting at least one first-type sub-sequence from the unsent first-type sequence as the part of the to-be-transmitted sequence to be sent in the current transmission, where an amount of resources required for sending the selected at least one first-type sub-sequence is less than the amount of allocated resources; or in response to the resources allocated for the current transmission being sufficient to send the unsent first-type sequence, determining the unsent first-type sequence as the part of the to-be-transmitted sequence to be sent in the current transmission. In this way, even if the amount of allocated resources in a data transmission process is insufficient, data does not need to be excessively compressed based on the amount of allocated resources. Instead, the sequence may be transmitted through a plurality of transmissions, and a part of the sequence is sent in each transmission. This avoids an unnecessary data loss caused by excessive compression.

In some implementations, selecting the at least one first-type sub-sequence from the unsent first-type sequence may include: selecting the at least one first-type sub-sequence based on a sub-codebook corresponding to the unsent first-type sequence. In this way, a data transmission sending apparatus can more effectively determine the part of the sequence that can be sent based on the allocated resources.

In some implementations, when the amount of resources allocated for the current transmission is sufficient to send the unsent first-type sequence, determining the part of the to-be-transmitted sequence to be sent in the current transmission may further include: determining an amount of remaining available resources based on the amount of resources allocated for the current transmission and an amount of resources used to send the unsent first-type sequence, where in response to the amount of remaining available resources being sufficient to send at least one second-type sub-sequence of an unsent second-type sequence, the part of the to-be-transmitted sequence may further include the at least one second-type sub-sequence, where the second-type sequence is a sequence different from the first-type sequence in the first-level sequence and the second-level sequence. In this way, the amount of resources allocated for each transmission can be maximized to transmit more data.

In some implementations, the at least one second-type sub-sequence may be determined based on a sub-codebook corresponding to the unsent second-type sequence, and sending the part of the compressed sequence further includes: sending a number of a sub-codebook corresponding to each second-type sub-sequence in the at least one second-type sub-sequence. In this way, the data transmission receiving apparatus can effectively distinguish between sub-codebooks corresponding to the received sequences or sub-sequences, thereby accurately restoring the original sequence.

In some implementations, when the to-be-transmitted sequence is obtained based on the multi-layer sequence, determining the part of the to-be-transmitted sequence to be sent in the current transmission may include: based on an order of layers from high to low at which unsent to-be-transmitted sequences are located in the multi-layer sequence, determining, as the part of the to-be-transmitted sequence to be sent in the current transmission, sequences of a quantity of layers that are transmittable by using the amount of resources allocated for the current transmission. In this way, even if the amount of allocated resources in a data transmission process is insufficient, data does not need to be excessively compressed based on the amount of allocated resources. Instead, the sequence may be transmitted through a plurality of transmissions, and a part of the sequence is sent in each transmission. This avoids an unnecessary data loss caused by excessive compression.

In some implementations, sending the part of the compressed sequence may further include: sending sequence symbol indication information, sequence length information, and sequence position information of a sequence in the part of the to-be-transmitted sequence. In this way, the data transmission receiving apparatus can accurately restore the original sequence based on the sequence information.

In some implementations, determining the part of the to-be-transmitted sequence to be sent in the current transmission may further include: determining an amount of remaining available resources based on the amount of resources allocated for the current transmission and an amount of resources used to send the sequences of the quantity of layers, where in response to the amount of remaining available resources being sufficient to send at least one sub-sequence of a sequence at a layer lower than the sequences of the quantity of layers, the part of the to-be-transmitted sequence further includes the at least one sub-sequence, where the at least one sub-sequence may include at least one sub-sequence of a first-level sequence or a second-level sequence at the lower layer. In this way, the amount of resources allocated for each transmission can be maximized to transmit more data.

In some implementations, the at least one sub-sequence may be determined based on a sub-codebook corresponding to the first-level sequence or the second-level sequence at the lower layer, and if the at least one sub-sequence is at least one sub-sequence of the second-level sequence, sending the part of the compressed sequence further includes: sending a number of a sub-codebook corresponding to a sub-sequence in the at least one sub-sequence and a position that is of a sequence to which the at least one sub-sequence belongs and that is at the lower layer. In this way, the data transmission sending apparatus can more efficiently determine, based on the amount of allocated resources, a part of the sequence to be sent, and further enable the data transmission receiving apparatus to effectively distinguish between sub-codebooks corresponding to the received sequences or sub-sequences, thereby accurately restoring the original sequence.

In some implementations, determining the to-be-hierarchized sequence in the sequences at layer 1 includes: performing entropy encoding on a first-level sequence and a second-level sequence that are at layer 2 and that correspond to each the sequences at layer 1, to obtain a first length corresponding to an encoded sequence; performing entropy encoding on the sequences at layer 1, to obtain second lengths corresponding to encoded sequences; and determining a sequence that is at layer 1 and whose first length is less than the second length as the to-be-hierarchized sequence. In this way, sequences can be hierarchized only when a data amount can be reduced through hierarchization, thereby improving compression efficiency.

In some implementations, before determining the to-be-hierarchized sequence in the sequences at layer 1, the method further includes: determining whether layer 1 has reached a quantity of layers of the multi-layer sequence; and determining, based on determining that layer 1 has reached the quantity of layers, that no to-be-hierarchized sequence exists; or determining, based on determining that layer 1 has not reached the quantity of layers, the to-be-hierarchized sequence in the sequences at layer 1. In this way, hierarchization can be performed more effectively, thereby improving compression efficiency.

In some implementations, sending the compressed sequence may further include: combining, by using a preset quantity of elements as a group, a plurality of adjacent elements in the to-be-transmitted sequence as a single element, to obtain a combined to-be-transmitted sequence; and sending a compressed sequence obtained based on the combined to-be-transmitted sequence. In this way, a quantity of data elements to be entropy encoded can be reduced, thereby further improving compression efficiency of entropy encoding.

In some implementations, the codebook splitting information is obtained in one of the following manners: pre-configured; determined by an apparatus that sends the compressed sequence; or received from an apparatus that receives the compressed sequence. In this way, the data transmission sending apparatus and the data transmission receiving apparatus can use a same codebook or sub-codebook to effectively implement compression and decompression of a data sequence.

According to a second aspect of this application, a method is provided. The method includes: obtaining codebook splitting information, where the codebook splitting information indicates to split an overall codebook into a plurality of sub-codebooks; receiving a compressed sequence, where the compressed sequence is generated based on a first-level sequence and a second-level sequence, the first-level sequence includes a number of a sub-codebook, among the plurality of sub-codebooks, to which each element in an original sequence belongs, the second-level sequence includes a position of the element in the sub-codebook to which the element belongs, and the original sequence is generated based on the overall codebook; and obtaining the original sequence based on the codebook splitting information and the compressed sequence. In this way, compared with a compressed sequence obtained based on the original sequence, a data amount of the compressed sequence obtained based on the first-level sequence and the second-level sequence determined from the original sequence can be further reduced, so that an amount of resources required for data transmission can be effectively reduced.

In some implementations, the compressed sequence may be generated based on a to-be-transmitted sequence that is determined based on the first-level sequence and the second-level sequence and that corresponds to the original sequence. In this way, after the original sequence is hierarchized into the first-level sequence and the second-level sequence, a necessary hierarchized sequence among hierarchized sequences may be sent, thereby improving data transmission efficiency.

In some implementations, the to-be-transmitted sequence may include the first-level sequence and the second-level sequence, and the compressed sequence may be obtained in the following manners: separately performing entropy encoding on the first-level sequence and the second-level sequence; or performing entropy encoding on the first-level sequence and the second-level sequence together. In this way, entropy encoding efficiency of data can be improved.

In some implementations, the to-be-transmitted sequence may include at least one of the first-level sequence and the second-level sequence in a multi-layer sequence that are determined as not belonging to a to-be-hierarchized sequence, and the compressed sequence is generated in the following manners: separately performing entropy encoding on the first-level sequence and the second-level sequence in the to-be-transmitted sequence; or performing entropy encoding on the first-level sequence and the second-level sequence in the to-be-transmitted sequence together. In this way, the multi-layer sequence can be compressed more effectively through entropy encoding.

In some implementations, entropy encoding may be separately performed on a plurality of sequences in the second-level sequence that belong to different sub-codebooks. In this way, compression efficiency of the second-level sequence can be further improved.

In some implementations, receiving the compressed sequence may further include: receiving sequence information associated with the to-be-transmitted sequence, where the sequence information includes: sequence length information, indicating a sequence length of the to-be-transmitted sequence. In this way, a data transmission receiving apparatus can effectively restore data in each sequence based on length information of the sequence.

In some implementations, when the to-be-transmitted sequence is obtained based on the multi-layer sequence, the sequence information may further include: sequence position information, indicating a layer at which a sequence in the to-be-transmitted sequence is located, a position of the sequence at the layer, and a position of a corresponding upper-layer sequence at an upper layer. In this way, the data transmission receiving apparatus can further restore the corresponding upper-layer sequence level by level based on sequence position information of each hierarchized sequence, to accurately restore the original sequence.

In some implementations, the sequence information may further include: sequence symbol indication information, indicating whether the sequence in the to-be-transmitted sequence is a first-level sequence or a second-level sequence. In this way, the data transmission receiving apparatus can effectively distinguish between the first-level sequence and the second-level sequence, and restore the upper-layer sequence level by level based on a corresponding sub-codebook, to accurately restore the original sequence.

In some implementations, receiving the compressed sequence may include: receiving the compressed sequence through a plurality of transmissions, where one of the plurality of transmissions includes: receiving a part of the compressed sequence generated based on a part of the to-be-transmitted sequence, where the part of the to-be-transmitted sequence is determined based on an amount of resources allocated for a current transmission. In this way, even if the amount of allocated resources in a data transmission process is insufficient, the sequence does not need to be further compressed to a data amount that can be sent at a time by using the amount of allocated resources. Instead, the sequence may be transmitted through a plurality of transmissions. This avoids an unnecessary data loss caused by excessive compression.

In some implementations, the part of the to-be-transmitted sequence may include: a part of the first-level sequence in an unsent part of the first-level sequence in the to-be-transmitted sequence and a part of the second-level sequence in an unsent part of the second-level sequence in the to-be-transmitted sequence, where an element in the part of the first-level sequence corresponds to an element in the part of the second-level sequence; and an amount of resources required for transmitting the part of the first-level sequence and the part of the second-level sequence is less than the amount of allocated resources. In this way, only a part of the first-level sequence and a part of the second-level sequence that correspond to each other may be transmitted in each transmission process, so that the data transmission receiving apparatus can restore a part of the original sequence based on the part of the first-level sequence and the part of the second-level sequence that correspond to each other without waiting for receiving all sequences, thereby improving data processing efficiency at the receiving apparatus.

In some implementations, receiving the part that is of the compressed sequence and that is obtained based on the part of the to-be-transmitted sequence may further include: receiving sequence information associated with the part of the to-be-transmitted sequence, where the sequence information associated with the part of the to-be-transmitted sequence includes sequence symbol indication information indicating whether a sequence to which the part of the to-be-transmitted sequence belongs is a first-level sequence or a second-level sequence. In this way, the data transmission receiving apparatus can effectively determine whether each received part of the sequence belongs to the first-level sequence or the second-level sequence, and accurately restore a corresponding part of the original sequence.

In some implementations, when the to-be-transmitted sequence is obtained based on the multi-layer sequence, the sequence information associated with the part of the to-be-transmitted sequence may further include sequence position information of the sequence to which the part of the to-be-transmitted sequence belongs. In this way, the data transmission receiving apparatus can effectively determine a position of each received part of the sequence, and therefore, restore an upper-layer sequence level by level based on a sub-codebook corresponding to the received part of the sequence, so that the corresponding part of the original sequence can be accurately restored.

In some implementations, when a first-type sequence that is not transmitted exists: in response to the amount of resources allocated for the current transmission being insufficient to transmit the first-type sequence that is not transmitted, the part of the to-be-transmitted sequence may include at least one first-type sub-sequence selected from the first-type sequence that is not transmitted, where an amount of resources required for transmitting the selected at least one first-type sub-sequence is less than the amount of allocated resources; or in response to the resources allocated for the current transmission being sufficient to transmit the first-type sequence that is not transmitted, the part of the to-be-transmitted sequence includes the first-type sequence that is not transmitted, where the first-type sequence includes a first-level sequence or a second-level sequence. In this way, even if the amount of allocated resources in a data transmission process is insufficient, data does not need to be excessively compressed based on the amount of allocated resources. Instead, the sequence may be transmitted through a plurality of transmissions, and a part of the sequence is sent in each transmission. This avoids an unnecessary data loss caused by excessive compression.

In some implementations, the at least one first-type sub-sequence may be selected based on a sub-codebook corresponding to the first-type sequence that has not been received. In this way, a data transmission sending apparatus can more effectively determine the part of the sequence that can be sent based on the allocated resources.

In some implementations, when the amount of resources allocated for the current transmission is sufficient to send the unsent first-type sequence, in response to an amount of remaining available resources determined based on the amount of resources allocated for the current transmission and an amount of resources used to send the unsent first-type sequence being sufficient to send at least one second-type sub-sequence of an unsent second-type sequence, the part of the to-be-transmitted sequence further includes the at least one second-type sub-sequence, where the second-type sequence is a sequence different from the first-type sequence in the first-level sequence and the second-level sequence. In this way, the amount of resources allocated for each transmission can be maximized to transmit more data.

In some implementations, the at least one second-type sub-sequence may be determined based on a sub-codebook corresponding to the second-type sequence that has not been received, and receiving the part of the compressed sequence may further include: receiving a number of a sub-codebook corresponding to a second-type sub-sequence in the at least one second-type sub-sequence. In this way, the data transmission receiving apparatus can effectively distinguish between sub-codebooks corresponding to the received sequences or sub-sequences, thereby accurately restoring the original sequence.

In some implementations, when the to-be-transmitted sequence is obtained based on the multi-layer sequence, the part of the to-be-transmitted sequence may include: based on an order of layers from high to low at which to-be-transmitted sequences that are not transmitted are located in the multi-layer sequence, sequences of a quantity of layers that are transmittable by using the amount of resources allocated for the current transmission. In this way, even if the amount of allocated resources in a data transmission process is insufficient, data does not need to be excessively compressed based on the amount of allocated resources. Instead, the sequence may be transmitted through a plurality of transmissions, and a part of the sequence is sent in each transmission. This avoids an unnecessary data loss caused by excessive compression.

In some implementations, receiving the part of the compressed sequence further includes: receiving sequence symbol indication information, sequence length information, and sequence position information of a sequence in the part of the to-be-transmitted sequence. In this way, the data transmission receiving apparatus can accurately restore the original sequence based on the sequence information.

In some implementations, in response to an amount of remaining available resources determined based on the amount of resources allocated for the current transmission and an amount of resources used to send the sequences of the quantity of layers being sufficient to send at least one sub-sequence of a sequence at a layer lower than the sequences of the quantity of layers, the part of the to-be-transmitted sequence further includes the at least one sub-sequence, where the at least one sub-sequence includes at least one sub-sequence of a first-level sequence or a second-level sequence at the lower layer. In this way, the amount of resources allocated for each transmission can be maximized to transmit more data.

In some implementations, the at least one sub-sequence may be determined based on a sub-codebook corresponding to the first-level sequence or the second-level sequence at the lower layer, and if the at least one sub-sequence is at least one sub-sequence of the second-level sequence, receiving the part of the compressed sequence may further include: receiving a number of a sub-codebook corresponding to a sub-sequence in the at least one sub-sequence and a position that is of a sequence to which the at least one sub-sequence belongs and that is at the lower layer. In this way, the data transmission sending apparatus can more efficiently determine, based on the amount of allocated resources, a part of the sequence to be sent, and further enable the data transmission receiving apparatus to effectively distinguish between sub-codebooks corresponding to the received sequences or sub-sequences, thereby accurately restoring the original sequence.

In some implementations, obtaining the original sequence may include: performing entropy decoding on the compressed sequence to obtain a combined hierarchized sequence; splitting each element in the combined hierarchized sequence into a group of a predetermined quantity of adjacent elements to obtain hierarchized sequences; and obtaining the original sequence based on the codebook splitting information and the hierarchized sequences. In this way, a quantity of elements in data on which entropy encoding is performed is reduced, thereby further improving compression and decompression efficiency of entropy encoding and entropy decoding.

In some implementations, the codebook splitting information may be obtained in one of the following manners: pre-configured; determined by an apparatus that receives the compressed sequence; or received from an apparatus that sends the compressed sequence. In this way, the data transmission sending apparatus and the data transmission receiving apparatus can use a same codebook or sub-codebook to effectively implement compression and decompression of a data sequence.

According to a third aspect of this application, a first apparatus is provided. The first apparatus includes a module configured to perform the method according to the first aspect of this application.

In some implementations, the first apparatus may be a terminal device or a network device, or may be an apparatus (for example, a chip, a chip system, or a circuit) in the terminal device or the network device, or may be an apparatus that can be used together with the terminal device or the network device.

In some implementations, the first apparatus may include modules or units that are in one-to-one correspondence with the method/operations/steps/actions described in the first aspect. The modules or units may be hardware circuits or software, or may be implemented by the hardware circuits in combination with the software.

According to a fourth aspect of this application, a second apparatus is provided. The second apparatus includes a module configured to perform the method according to the second aspect of this application.

In some implementations, the second apparatus may be a terminal device or a network device, or may be an apparatus (for example, a chip, a chip system, or a circuit) in the terminal device or the network device, or may be an apparatus that can be used together with the terminal device or the network device.

In some implementations, the second apparatus may include modules or units that are in one-to-one correspondence with the method/operations/steps/actions described in the second aspect. The modules or units may be hardware circuits or software, or may be implemented by the hardware circuits in combination with the software.

According to a fifth aspect of this application, an electronic device is provided. The electronic device includes a processor, configured to cause, by executing a computer program (or computer-executable instructions) stored in a memory and/or by using a logic circuit, the device to perform the method according to the first aspect and various possible implementations of the first aspect or the second aspect and various possible implementations of the second aspect.

In a possible implementation, the apparatus may further include the memory.

In a possible implementation, the processor and the memory may be integrated together.

In another possible implementation, the memory may be located outside the electronic device.

A communication apparatus may further include a communication interface. The communication interface is for communication between the communication apparatus and another device, for example, for data and/or signal sending or receiving. For example, the communication interface may be a transceiver, a circuit, a bus, a module, or another type of communication interface.

According to a sixth aspect of this application, a communication apparatus is provided. The communication apparatus includes a processor and a communication interface, where the processor is configured to perform the method according to the first aspect or the second aspect of this application using the communication interface.

According to a seventh aspect of this application, a communication system is provided. The communication system includes at least one of a first apparatus and a second apparatus. The first apparatus is configured to perform the method according to the first aspect of this application, and the second apparatus is configured to perform the method according to the second aspect of this application.

According to an eighth aspect of this application, a computer-readable storage medium is provided. The computer-readable storage medium stores instructions. When the instructions are executed by an electronic apparatus, the electronic apparatus is caused to perform the method according to the first aspect or the second aspect of this application.

According to a ninth aspect of this application, a computer program product is provided. The computer program product includes instructions. When the instructions are executed by an electronic apparatus, the electronic apparatus is caused to perform the method according to the first aspect or the second aspect of this application.

When this application is read with reference to the accompanying drawings, other features and advantages of embodiments of this application will become apparent from the following descriptions of specific embodiments. The accompanying drawings illustrate principles of embodiments of this application by way of example.

### BRIEF DESCRIPTION OF DRAWINGS

Embodiments of this application are presented by using examples, and the following explains these embodiments in detail below with reference to the accompanying drawings, in which:
FIG. 1 shows an example of a data compression procedure;
FIG. 2 shows an example scenario to which an example embodiment of this application is applied;
FIG. 3 shows a flowchart of a data compression method according to an example embodiment of this application;
FIG. 4A and FIG. 4B show examples of data compression according to example embodiments of this application;
FIG. 5A and FIG. 5B show other examples of data compression according to example embodiments of this application;
FIG. 6 shows a flowchart of a method for transmitting a compressed sequence according to an example embodiment of this application;
FIG. 7A and FIG. 7B show examples of transmitting a compressed sequence according to example embodiments of this application;
FIG. 8A to FIG. 8C show other examples of transmitting a compressed sequence according to example embodiments of this application;
FIG. 9A to FIG. 9C show other examples of transmitting a compressed sequence according to example embodiments of this application;
FIG. 10 shows a flowchart of a method for sending compressed data according to an example embodiment of this application;
FIG. 11 shows a flowchart of a method for receiving compressed data according to an example embodiment of this application;
FIG. 12 shows a block diagram of an apparatus that sends compressed data according to an example embodiment of this application;
FIG. 13 shows a block diagram of an apparatus that receives compressed data according to an example embodiment of this application;
FIG. 14 is a diagram of a structure of an example electronic device that can implement embodiments of this application; and
FIG. 15 is a diagram of a structure of an example communication apparatus that can implement embodiments of this application.

In the accompanying drawings, same or similar reference signs represent same or similar elements.

### DESCRIPTION OF EMBODIMENTS

The following describes embodiments of this application in more detail with reference to the accompanying drawings. Although some embodiments of this application are shown in the accompanying drawings, it should be understood that this application may be implemented in various forms and should not be construed as being limited to embodiments described herein, and instead, these embodiments are provided for a more thorough and complete understanding of this application. It should be understood that, the accompanying drawings and embodiments of this application are merely used as examples, but are not used to limit the protection scope of this application.

In descriptions of embodiments of this application, the term "including" and similar terms thereof should be understood as open inclusion, namely, "including but not limited to". The term "based on" should be understood as "at least partially based on". The term "one embodiment" or "this embodiment" should be understood as "at least one embodiment". The terms "first", "second", and the like may indicate different objects or a same object. Other explicit and implicit definitions may also be included below.

Embodiments of this application may be implemented according to any appropriate communication protocol, including but not limited to cellular communication protocols such as a 5th generation (5th generation, 5G) and a communication protocol evolved after 5G (for example, a 6th generation (6th generation, 6G)), a wireless local area network communication protocol like the Institute of Electrical and Electronics Engineers (institute of electrical and electronics engineers, IEEE) 802.11, and/or any other protocol that is currently known or developed in the future.

Technical solutions in embodiments of this application are applied to a communication system that complies with any appropriate communication protocol, for example, a long term evolution (long term evolution, LTE) system, a frequency division duplex (frequency division duplex, FDD) system, a time division duplex (time division duplex, TDD) system, a 5th generation (5G) system (for example, new radio (new radio, NR)) and a communication system evolved after 5G (for example, a 6th generation (6G) system), and the like.

The term "terminal" or "terminal device" used in this disclosure means any terminal device that can perform wired or wireless communication with a network device or between terminal devices. A terminal device may also be referred to as user equipment (user equipment, UE), a mobile station (mobile station, MS), a mobile terminal (mobile terminal, MT), or the like, or is a device that is configured to provide voice or data connectivity for a user, or may be an internet of things device. The terminal device may be any type of mobile terminal, fixed terminal, or portable terminal. The terminal device may be various wireless communication devices that have a wireless communication function. For example, the terminal device includes a handheld device, a vehicle-mounted device, or the like that has a wireless connection function. Currently, the terminal device may be a mobile cellular phone, a cordless phone, a mobile terminal (mobile terminal, MT), a mobile station, a mobile device, a wireless terminal, a handheld device, a client, a subscription station, a portable subscription station, an internet node, a communicator, a desktop computer, a laptop computer, a notebook computer, a tablet computer, a personal communication system device, a personal navigation device, a personal digital assistant (personal digital assistant, PDA), a wireless data card, a wireless modem (modulator demodulator, Modem), a positioning device, a radio broadcast receiver, an e-book device, a game device, an internet of things (internet of things, IoT) device, a palmtop computer, a mobile internet device (mobile internet device, MID), a wearable device (for example, a smartwatch, a smart band, a pedometer, or smart glasses), a vehicle-mounted device (for example, a car, a bicycle, an electric vehicle, an airplane, a ship, a train, or a high-speed railway), a satellite terminal, a virtual reality (virtual reality, VR) device, an augmented reality (augmented reality, AR) device, a smart point of sale (point of sale, POS) machine, customer-premises equipment (customer-premises equipment, CPE), a wireless terminal in industrial control, a smart home device (for example, a refrigerator, a television, an air conditioner, or an electricity meter), a smart robot, a robot arm, a workshop device, a wireless terminal in self-driving, a wireless terminal in remote medical, a wireless terminal in a smart grid (smart grid), a wireless terminal in transportation security, a wireless terminal in a smart city, a wireless terminal in a smart home, a flight device (for example, a smart robot, a hot air balloon, an uncrewed aerial vehicle, or an airplane), or the like. The terminal device may alternatively be a vehicle apparatus, for example, an entire vehicle apparatus, a vehicle-mounted module, a vehicle-mounted chip, an on board unit (on board unit, OBU), or a telematics box (telematics box, T-BOX), or any combination thereof. The terminal device may alternatively be another device having a function of a terminal. For example, the terminal device may alternatively be a device that functions as a terminal in D2D communication. In addition, with emergence of internet of things (internet of things, IoT) technologies, increasingly more devices that previously do not have a communication function, for example, but not limited to, a household appliance, a transportation vehicle, a tool device, a service device, and a service facility, start to obtain a wireless communication function by being configured with a wireless communication unit, to access a wireless communication network to accept remote control. Such a device has the wireless communication function because the device is configured with the wireless communication unit, and is therefore classified as a wireless communication device. This is not limited in embodiments of this application.

In addition, a device form of the terminal is not limited in embodiments of this application. An apparatus configured to implement a function of the terminal device may be a terminal device, or may be an apparatus, for example, a chip system, that can support the terminal device in implementing the function. The apparatus may be mounted in the terminal device or used together with the terminal device. In embodiments of this application, the chip system may include a chip, or may include a chip and another discrete component.

The term "network node" or "network device" used in this application is an entity or node that can be used to communicate with the terminal device, for example, may be an access network device. The access network device may be an apparatus that is deployed in a radio access network and that provides a wireless communication function for a mobile terminal, for example, may be a radio access network (radio access network, RAN) network device. The access network device may include various types of base stations. The base station is configured to provide a radio access service for the terminal device. Specifically, each base station corresponds to a service coverage area, and a terminal device entering the area may communicate with the base station by using a radio signal, to receive the radio access service provided by the base station. The service coverage areas of base stations may overlap, and a terminal device in an overlapping area may receive radio signals from a plurality of base stations. Therefore, the plurality of base stations may simultaneously provide services for the terminal device. Based on a size of the provided service coverage area, the access network device may include a macro base station for providing a macro cell (Macro cell), a micro base station for providing a micro cell (micro cell), a pico base station for providing a pico cell, and a femto base station for providing a femto cell (femto cell). In addition, the access network device may further include various forms of relay stations, access points, remote radio units (remote radio units, RRUs), radio heads (radio heads, RHs), remote radio heads (remote radio heads, RRHs), and the like. In systems using different radio access technologies, the access network device may have different names. For example, the access network device is referred to as an evolved NodeB (evolved NodeB, eNB or eNodeB) in a long term evolution (long term evolution, LTE) system network, is referred to as a NodeB (NodeB, NB) in a 3G network, and may be referred to as a gNodeB (gNB) or an NR NodeB (NR NB) in a 5G network. In some scenarios, the access network device may include a central unit (central unit, CU) and/or a distributed unit (distributed unit, DU). The CU and DU may be deployed in different places. For example, the DU is remotely deployed in a high-traffic area, and the CU is deployed in a central equipment room. Alternatively, the CU and the DU may be deployed in a same equipment room. Alternatively, the CU and the DU may be different components in a same rack.

In addition, a plurality of network devices in a communication system may be nodes of a same type, or may be nodes of different types. In some scenarios, roles of the network device and the terminal are relative. For example, a network element may be a helicopter or an uncrewed aerial vehicle, and may be configured as a mobile base station. For a terminal that accesses a network through the network element, the network element is a base station. However, for the base station, the network element is a terminal. The network device and the terminal are sometimes both referred to as communication apparatuses. The network device may be understood as a communication apparatus having a function of a base station, and the terminal may be understood as a communication apparatus having a function of a terminal.

In a possible scenario, the network device may be a base station (base station), an evolved base station (evolved NodeB, eNodeB), a transmission reception point (transmission reception point, TRP), a transmission point (transmission point, TP), a next generation NodeB (next generation NodeB, gNB), a next generation base station in a 6th generation (6th generation, 6G) mobile communication system, a base station in a future mobile communication system, a satellite, an access point (access point, AP) in a Wi-Fi system, an integrated access and backhaul (integrated access and backhaul, IAB) node, or a network device that is in a non-terrestrial network (non-terrestrial network, NTN) communication system of a mobile switching center and that may be deployed on a high-altitude platform or a satellite, or the like. The network device may be a macro base station, a micro base station or an indoor base station, a relay node or a donor node, or a radio controller in a cloud radio access network (cloud radio access network, CRAN) scenario. The network device may alternatively be a device that functions as a base station in device-to-device (device-to-device, D2D) communication, vehicle-to-everything communication, uncrewed aerial vehicle communication, or machine communication. Optionally, the network device may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, a plurality of network devices collaborate to assist a terminal in implementing radio access, and different network devices separately implement a part of functions of the base station. For example, the network device may be a CU, a DU, a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network (core network, CN). This is not limited herein.

In different systems, the CU (or the CU-CP and the CU-UP), the DU, or the RU may alternatively have different names, but a person skilled in the art may understand meanings thereof. For example, in an open RAN (open RAN, ORAN) system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

A form of the network device is not limited in embodiments of this application. An apparatus for implementing a function of the network device may be a network device, or may be an apparatus, for example, a chip system, that can support the network device in implementing the function. The apparatus may be mounted in the network device or used together with the network device.

For ease of description, in the following embodiments of this application, the foregoing apparatuses that provide the wireless communication function for a mobile terminal are collectively referred to as network devices. This is not specifically limited in embodiments of this application. It may be understood that all or a part of functions of the network device in this application may alternatively be implemented by using a software function running on hardware, or may be implemented by using an instantiated virtualization function on a platform (for example, a cloud platform).

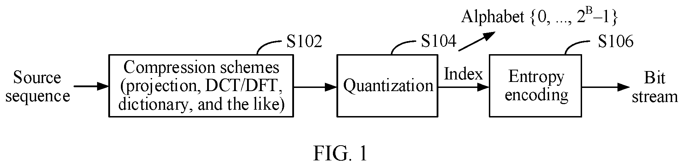

A data compression procedure usually may include three steps, to be specific, applying compression to data, performing quantization, and performing entropy encoding. FIG. 1 shows an example of a data compression procedure. As shown in FIG. 1, a source data sequence is first compressed in a compression step S102 by using compression schemes such as projection, discrete cosine transform (DCT)/discrete Fourier transform (DFT), and a dictionary, then quantized into an index sequence (an element in an alphabet (alphabet) may represent a value range of an index in the index sequence) in a quantization step S104, and finally entropy-encoded in an entropy encoding step S106 for a quantized index sequence to further compress the quantized index sequence, to finally obtain a to-be-transmitted bit stream. If distribution of the index sequence is known, data can be approximately compressed to a theoretical limit through entropy encoding. However, when the distribution of the index sequence is unknown, there is still room for further improving compression performance of entropy encoding.

To further improve the compression performance of entropy encoding in a data transmission process, a frequency of occurrence of a same element in the index sequence may be increased. For example, the frequency of occurrence of the same element in the index sequence may be increased by reducing an alphabet size (alphabet size) of the quantized index sequence. The alphabet refers to a value set of indexes in the index sequence. For example, if the alphabet is {0, 1, 2, 3}, it indicates that each index in the index sequence is an element whose value is {0, 1, 2, 3}. The alphabet size refers to a quantity of elements in the alphabet. For example, when the alphabet is {0, 1, 2, 3}, the alphabet size is 4.

An embodiment of this application provides a solution to further reduce a compressed data amount by reducing the alphabet size of the quantized index sequence before entropy encoding is performed. According to this embodiment of this application, an overall codebook corresponding to the index sequence obtained through quantization may be split into a plurality of sub-codebooks, and then the index sequence is hierarchized into one layer of first-level sequence and second-level sequence or a plurality of layers of first-level sequences and second-level sequences based on the plurality of sub-codebooks. The first-level sequence includes a number of a sub-codebook corresponding to an element in an associated upper-layer sequence, and the second-level sequence includes a position of the element in the associated upper-layer sequence in the sub-codebook to which the element belongs. In addition, in an example embodiment of this application, a sequence that is in the layer of first-level sequence and second-level sequence or the plurality of layers of first-level sequences and the second-level sequences and that is not associated with a lower-layer hierarchized sequence may be determined as a to-be-transmitted sequence, and the original index sequence is not sent. Because an alphabet size of the to-be-transmitted sequence obtained through hierarchization is greatly reduced compared with an alphabet size of the original sequence, compression efficiency of a subsequent entropy encoding step can be improved.

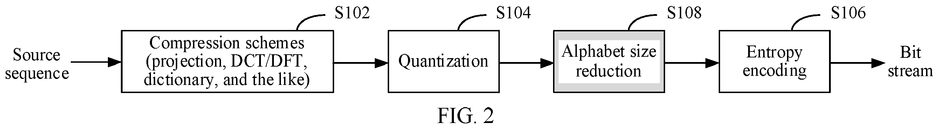

FIG. 2 shows an example scenario to which an example embodiment of this application is applied. Refer to FIG. 2. After an index sequence is obtained through the quantization step S104, in step S108, an alphabet size corresponding to the index sequence may be reduced to further process the index sequence, so that a frequency of occurrence of a same element in a processed index sequence is increased, and a higher compression rate can be obtained in the subsequent entropy encoding step S106. The following describes in more detail a solution for reducing an alphabet size according to an example embodiment of this application.

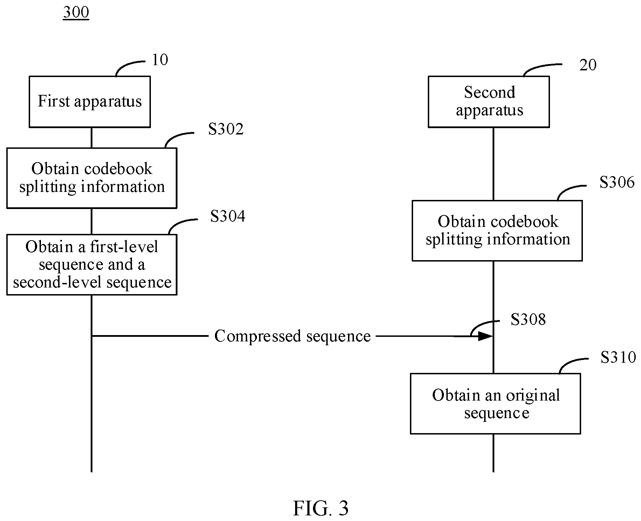

FIG. 3 shows a flowchart of a data compression method 300 according to an example embodiment of this application. The method 300 shown in FIG. 3 may be implemented on any apparatus that can send and receive data during data transmission. For example, the apparatus may be a network device, a terminal, or the like. For ease of explanation and brevity, in the following descriptions, a data sending apparatus is referred to as a first apparatus 10, a data receiving apparatus is referred to as a second apparatus 20, and an original index sequence obtained through quantization is referred to as an original sequence for short.

Refer to FIG. 3. In step S302, the first apparatus 10 may obtain codebook splitting information, where the codebook splitting information may indicate to split an overall codebook into a plurality of sub-codebooks.

In an example embodiment of this application, the overall codebook may be a codebook corresponding to the original sequence (namely, the original index sequence) obtained through a quantization step, and the sub-codebook may be a codebook obtained by splitting the overall codebook or further splitting a sub-codebook obtained by splitting the overall codebook. In addition, the codebook splitting information may indicate information about the plurality of sub-codebooks obtained through splitting. For example, the codebook splitting information includes one or more of the following: a specific codeword of the sub-codebook, a length of the sub-codebook, a position at which the sub-codebook is used, and the like. Merely as an example, it is assumed that an R-bit total codebook 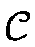 = {*c*₀, *c*₁, ··· , *c*_{2*_{R}*-1}} is given, where *cᵢ* is an *i*^{th} codeword, the overall codebook 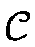 may be split into *M* sub-codebooks 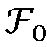 , 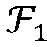 , ··· , 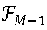 , and quantities of codewords in all the sub-codebooks may be set to be the same or different.

In step S304, the first apparatus 10 may obtain a first-level sequence and a second-level sequence for the original sequence obtained based on the overall codebook. The first-level sequence may include a number of a sub-codebook, among the plurality of sub-codebooks, to which each element in the original sequence belongs, and the second-level sequence may include a position of the element in the sub-codebook to which the element belongs. For example, for the overall codebook and sub-codebooks shown above, a group of data ${\left\{{s}_{k}\right\}}_{k = 0}^{K - 1}$ is given, for a *k*^{th} piece of data *sₖ* in total *K* pieces of data, a corresponding appropriate sub-codebook 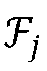 (where *j* ∈ [0, *M* - 1]) may be selected, to obtain a corresponding first-level sequence and a corresponding second-level sequence.

In step S306, the first apparatus 10 may send a compressed sequence obtained based on the first-level sequence and the second-level sequence.

The second apparatus 20 may receive, in step S308, the compressed sequence sent from the first apparatus 10, and obtain the original sequence based on the received compressed sequence and the codebook splitting information obtained in step S306. Although FIG. 3 shows that the second apparatus 20 obtains the codebook splitting information before receiving the compressed sequence, this application is not limited thereto. The second apparatus 20 may obtain the codebook splitting information when receiving the compressed sequence or after receiving the compressed sequence. This is not limited in this application.

In an example embodiment of this application, the codebook splitting information may be pre-configured, determined by the first apparatus 10 that sends the compressed sequence and sent to the second apparatus 20, or determined by the second apparatus 20 that receives the compressed sequence and sent to the first apparatus 10. In other words, the codebook splitting information is known or shared between the first apparatus 10 that sends the compressed sequence and the second apparatus 20 that receives the compressed sequence. In addition, a manner of splitting the overall codebook to obtain the sub-codebooks may be determined based on experience or historical data or in other manners. This is not limited in this application.

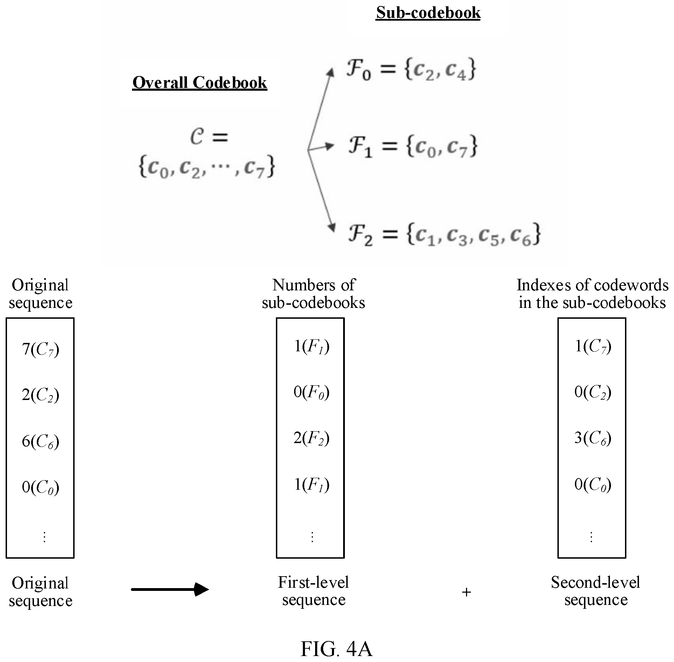

The following describes in detail steps of the data compression method 300 in FIG. 3 with reference to FIG. 4A to FIG. 9C.

FIG. 4A shows an example of data compression according to an example embodiment of this application.

In the example shown in FIG. 4A, for example, it is assumed that an overall codebook 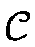 = {*c*₀, *c*₁, ··· , *c*₇} is split into three sub-codebooks 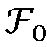 = {***c***₂, *c*₄}, 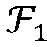 = {***c***₀, ***c***₇}, and 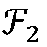 = {***c***₁, ***c***₃, ***c***₅, ***c***₆}. In this case, an original sequence {7, 2, 6, 0....} may be split into a first-level sequence {1, 0, 2, 1....} and a second-level sequence {1, 0, 3, 0....} shown in FIG. 4A in a hierarchization manner in step 304.

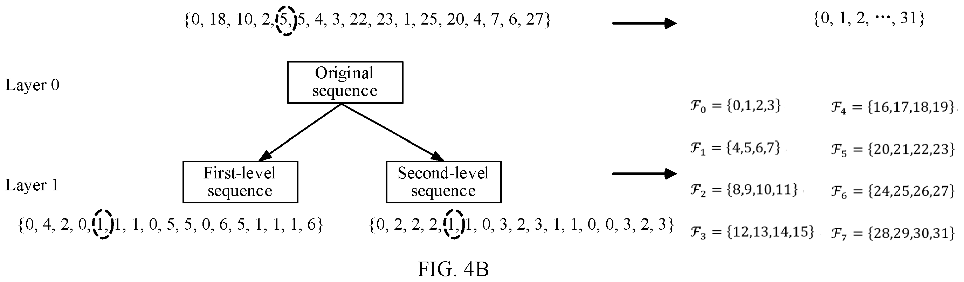

FIG. 4B shows another example of data compression according to an example embodiment of this application.

As shown in FIG. 4B, an overall codebook corresponding to an original sequence {0, 18, 10, 2, 5, 5, 4, 3, 22, 23, 1, 25, 20, 4, 7, 6, 27} is {0, 1, 2, ..., 31}, and the overall codebook is split into eight sub-codebooks: 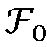 = {0,1,2,3} , 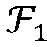 = {4,5,6,7} , 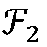 = {8,9,10,11} , 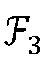 = {12,13,14,15} , 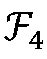 = {16,17,18,19} , 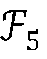 = {20,21,22,23} , 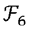 = {24,25,26,27}, and 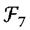 = {28,29,30,31}. Based on the eight sub-codebooks, the original sequence is hierarchized into two sequences at a lower layer, to be specific, a first-level sequence and a second-level sequence. A value of an element in the first-level sequence may indicate a number of a sub-codebook to which an element at a corresponding position in the original sequence belongs, and a value of an element in the second-level sequence may indicate a position that is of the element at the corresponding position in the original sequence and that is in the sub-codebook to which the element belongs.

Merely as an example, as shown in FIG. 4B, a value "1" of an element at a 5^{th} position in the first-level sub-sequence indicates a number of a sub-codebook 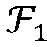 to which an element "5" at a corresponding 5^{th} position in the original sequence belongs, and a value "1" of an element at a 5^{th} position in the second-level sub-sequence indicates a position that is of the element "5" at the corresponding 5^{th} position in the original sequence and that is in the codebook 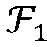 to which the element belongs, namely, a position whose index or number is 1 (herein, numbers or indexes of elements in the sub-codebook increase from 0). In this hierarchization manner, a first-level sequence {0, 4, 2, 0, 1, 1, 1, 0, 5, 5, 0, 6, 5, 1, 1, 1, 6} and a second-level sequence {0, 2, 2, 2, 1, 1, 0, 3, 2, 3, 1, 1, 0, 0, 3, 2, 3} that are at layer 1 and that correspond to the original sequence (which is assumed to be at the topmost layer 0) can be obtained.

After obtaining the first-level sequence and the second-level sequence through hierarchization, the first apparatus 10 may determine a to-be-transmitted sequence corresponding to the original sequence, to determine, based on the to-be-transmitted sequence, a compressed sequence to be transmitted.

Merely as an example, when the codebook splitting information indicates that the overall codebook is split only once to obtain a group of sub-codebooks, for example, in the case shown in FIG. 4A or FIG. 4B, the to-be-transmitted sequence may be the first-level sequence and the second-level sequence that are obtained from the original sequence based on the group of sub-codebooks. However, it should be understood that this application is not limited thereto. When the codebook splitting information indicates to perform nested splitting a plurality of times based on the overall codebook to obtain a plurality of groups of sub-codebooks, the first apparatus 10 can not only hierarchize the original sequence to obtain the first-level sequence and the second-level sequence (which may be referred to as the first-level sequence and the second-level sequence that are at layer 1 herein), but also continue to hierarchize at least one of the obtained first-level sequence and the obtained second-level sequence in the hierarchization manner described in step 304, to obtain a first-level sequence at layer 2 and a second-level sequence at layer 2. By analogy, the first apparatus 10 may hierarchize at least one of a first-level sequence and a second-level sequence at each layer in a same hierarchization manner until a hierarchization end condition is met, so that a multi-layer sequence may be obtained.

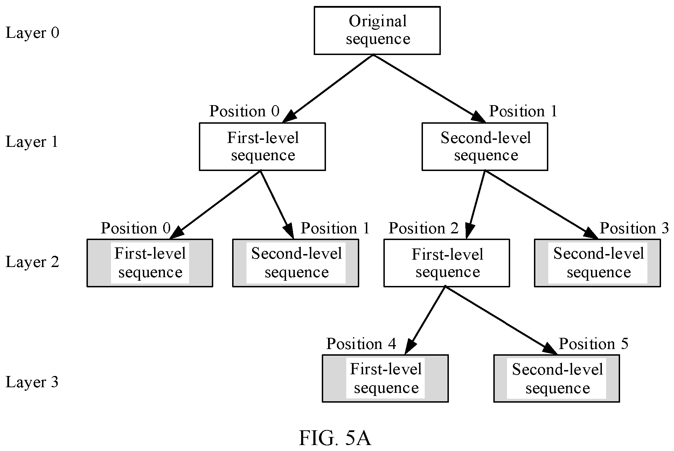

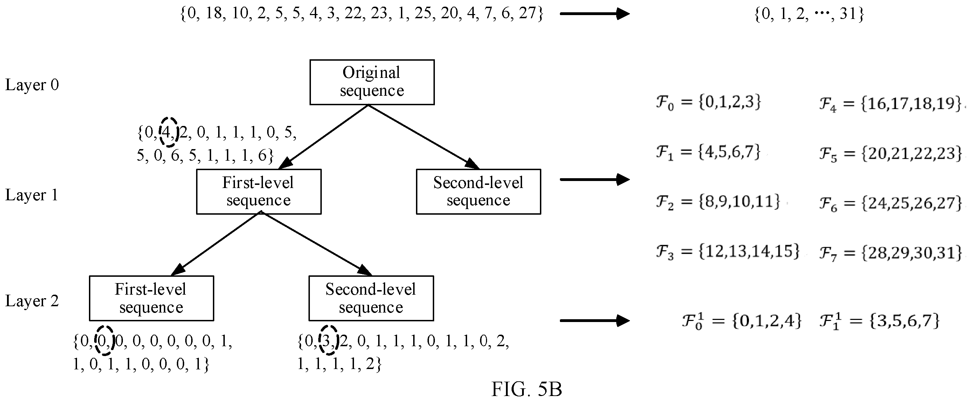

In an example embodiment of this application, the to-be-transmitted sequence may be obtained based on the multi-layer sequence. In detail, for example, the first-level sequence and the second-level sequence that are obtained by hierarchizing the original sequence may be respectively the first-level sequence at layer 1 in the multi-layer sequence and the second-level sequence at layer 1 in the multi-layer sequence, and one or more sub-codebooks used for hierarchizing the original sequence may be one or more sub-codebooks at layer 1. In an example embodiment of this application, the first apparatus 10 may obtain the multi-layer sequence in the following hierarchization manner: first determining a to-be-hierarchized sequence in the sequences at layer 1, and then obtaining the first-level sequence at layer 2 and the second-level sequence at layer 2 based on the to-be-hierarchized sequence at layer 1. The first-level sequence at layer 2 may include a number of a layer-2 sub-codebook, among the plurality of sub-codebooks, to which each element in the to-be-hierarchized sequence at layer 1 belongs, and the second-level sequence at layer 2 may include a position that is of the element and that is in the layer-2 sub-codebook to which the element belongs. In other words, the first apparatus 10 may determine numbers of one or more layer-2 sub-codebooks to which a plurality of elements in the to-be-hierarchized sequence separately belong, to obtain the first-level sequence at layer 2, determine positions that are of the plurality of elements in the to-be-hierarchized sequence and that are in the one or more layer-2 sub-codebooks to which the elements separately belong, to obtain the second-level sequence at layer 2, and perform hierarchization on a sequence layer by layer in a manner similar to nesting (in other words, continuing to hierarchize the sequence into a first-level sequence and a second-level sequence at a lower layer), to obtain the multi-layer sequence. The following describes in detail a manner of obtaining the multi-layer sequence with reference to FIG. 5A and FIG. 5B.

FIG. 5A and FIG. 5B show other examples of data compression according to example embodiments of this application.

FIG. 5A shows an example of obtaining a multi-layer sequence through hierarchization. Refer to FIG. 5A. After the original sequence at layer 0 is hierarchized into the first-level sequence at layer 1 and the second-level sequence at layer 1 as shown in FIG. 4A and FIG. 4B, the first apparatus 10 may further continue to perform hierarchization. For example, the first-level sequence at layer 1 is hierarchized into one first-level sequence and one second-level sequence at layer 2, and the second-level sequence at layer 1 is hierarchized into another first-level sequence and another second-level sequence at layer 2. The first apparatus 10 may further continue to perform hierarchization on the first-level sequence at layer 2 obtained by hierarchizing the second-level sequence at layer 1, to obtain a first-level sequence at layer 3 and a second-level sequence at layer 3. The rest may be deduced by analogy.

FIG. 5B shows an example of performing hierarchization on a sequence at layer 1 to obtain sequences at layer 2. Refer to FIG. 5B. It is assumed that the first-level sequence {0, 4, 2, 0, 1, 1, 1, 0, 5, 5, 0, 6, 5, 1, 1, 1, 6} at layer 1 obtained in FIG. 4B may be further hierarchized, and based on the codebook splitting information, sub-codebooks used by the first-level sequence at layer 1 are ${F}_{0}^{1} = \left\{0, 1, 2, 4\right\}$ and ${F}_{1}^{1} = \left\{3, 5, 6, 7\right\}$. According to the hierarchization manner in this embodiment of this application, a first-level sequence {0, 0, 0, 0, 0, 0, 0, 0, 1, 1, 0, 1, 1, 0, 0, 0, 1} at layer 2 and a second-level sequence {0, 3, 2, 0, 1, 1, 1, 0, 1, 1, 0, 2, 1, 1, 1, 1, 2} at layer 2 may be obtained. For example, for an element "4" at a 2^{nd} position in the first-level sequence at layer 1, a layer-2 sub-codebook to which the element belongs is ${F}_{0}^{1}$, and a position of the element in the sub-codebook is a 4^{th} position (namely, a position whose number is 3). Therefore, in the first-level sequence at layer 2, the 2^{nd} element corresponds to a number "0" of ${F}_{0}^{1}$, and in the second-level sequence at layer 2, the 2^{nd} element corresponds to the position number "3" of the element "4" in ${F}_{0}^{1}$.

In an example embodiment of this application, a manner of determining whether a sequence at a layer is a to-be-hierarchized sequence may be pre-specified. For example, positions that are in the multi-layer sequence and at which hierarchization needs to be performed and a quantity of layers to which the original sequence needs to be hierarchized may be directly specified based on experience. Merely as an example, that a sequence at a corresponding position does not need to be hierarchized may be indicated by not configuring a sub-codebook at the position. For example, refer to FIG. 5B. For the second-level sequence at layer 1, if there is no available sub-codebook based on the codebook splitting information, the first apparatus 10 may determine that the second-level sequence at layer 1 does not need to be hierarchized into sequences at a lower layer. However, for the first-level sequence at layer 1, as shown in FIG. 5B, because there is an available sub-codebook based on the codebook splitting information, the first apparatus 10 may determine that the first-level sequence at layer 1 is to be hierarchized into sequences at the lower layer.

In addition, positions of sequences to be hierarchized in the multi-layer sequence may not be predetermined. Instead, the first apparatus 10 may dynamically determine whether a sequence at each layer is a to-be-hierarchized sequence that needs to be further hierarchized. Merely as an example, when determining a to-be-hierarchized sequence in sequences at a layer (for example, layer 1 or layer 2), the first apparatus 10 may first determine whether the layer has reached a quantity of layers of the multi-layer sequence (the quantity of layers may be determined based on a layer division status of codebooks in the codebook splitting information). If the layer has reached the quantity of layers (for example, a maximum quantity of layers) of the multi-layer sequence, it may be determined that no to-be-hierarchized sequence exists, in other words, no sequence needs to be hierarchized. However, if the layer has not reached the quantity of layers of the multi-layer sequence, the first apparatus 10 may determine a to-be-hierarchized sequence at the layer. For example, the first apparatus 10 may perform entropy encoding on a first-level sequence and a second-level sequence at a lower layer (which may be obtained by using sub-codebooks separately corresponding to sequences at the layer) and that correspond to each sequence at the layer, to obtain a first length corresponding to an encoded sequence, and may further separately perform entropy encoding on each sequence at the layer, to obtain a second length corresponding to an encoded sequence. The first apparatus 10 may determine a sequence whose first length is less than the second length as the to-be-hierarchized sequence, and may determine that a sequence whose first length is greater than the second length does not need to be further hierarchized, in other words, does not belong to the to-be-hierarchized sequence. For example, the first apparatus 10 may use a sub-codebook (if available) corresponding to the second-level sequence at layer 1 in FIG. 5B, to hierarchize the second-level sequence at layer 1 into a first-level sequence and a second-level sequence at layer 2, and then perform entropy encoding on the first-level sequence and the second-level sequence that are at layer 2 and that are obtained through hierarchization, to obtain data of a first length. In addition, the first apparatus 10 may further perform entropy encoding on the second-level sequence at layer 1, to obtain data of a second length. If the first length is less than the second length, it indicates that a data amount can be further reduced by continuing to perform hierarchization. Therefore, the first apparatus 10 may determine the second-level sequence at layer 1 as the to-be-hierarchized sequence. If the first length is not less than the second length, it indicates that the data amount cannot be further reduced by performing hierarchization. In this case, the first apparatus 10 may determine not to perform further hierarchization. The first apparatus 10 may repeatedly perform the foregoing steps of determining a to-be-hierarchized sequence for a hierarchized sequence at each layer, until a predetermined quantity of layers of the multi-layer sequence is reached, or until it is determined that no to-be-hierarchized sequence exists.

In an example embodiment of this application, the first apparatus 10 may determine, as a to-be-transmitted sequence, a sequence that is not to be hierarchized, and perform entropy encoding on the to-be-transmitted sequence to obtain a compressed sequence. For example, in the case in which the original sequence shown in FIG. 4B is hierarchized only into hierarchized sequences at a single layer, both the first-level sequence and the second-level sequence that are obtained through hierarchization are to be sent. However, in the case in which the original sequence shown in FIG. 5A is hierarchized into the multi-layer sequence, a first-level sequence and a second-level sequence in the multi-layer sequence that are determined as not belonging to the to-be-hierarchized sequence may be determined as sequences to be sent, namely, to-be-transmitted sequences. For example, in FIG. 5A, a first-level sequence at position 0, a second-level sequence 2 at position 1, and a second-level sequence at position 3 that are at layer 2, and a first-level sequence at position 4 and a second-level sequence at position 5 that are at layer 3 may be to-be-transmitted sequences.

In an example embodiment of this application, the first apparatus 10 may separately perform entropy encoding on the first-level sequence and the second-level sequence in the to-be-transmitted sequence, or may perform entropy encoding on the first-level sequence and the second-level sequence together. In a possible implementation, the first apparatus 10 may alternatively separately perform, based on sub-codebooks, entropy encoding on a plurality of sequences or sub-sequences that belong to different sub-codebooks and that are in the second-level sequence in the to-be-transmitted sequence.

In an example embodiment of this application, before entropy encoding is performed, a plurality of adjacent elements in the to-be-transmitted sequence may be combined into a single element by using a preset quantity of elements as a group, to obtain a combined to-be-transmitted sequence, and entropy encoding is performed on the combined to-be-transmitted sequence to obtain the compressed sequence. For example, it is assumed that the to-be-transmitted sequence is {0, 0, 1, 1, 0, 0, 1, 0, 1, 0, ...}. Every two adjacent elements in the sequence may be combined to obtain a combined to-be-transmitted sequence {0, 3, 0, 2, 2, ...} (for example, two adjacent elements "0" are combined to obtain "00", which may be represented as "0" in the combined to-be-transmitted sequence, and two adjacent elements "1" are combined to obtain "11", which may be represented as "3" in the combined to-be-transmitted sequence). In this way, a length of the sequence (in other words, a quantity of elements in the sequence) can be reduced, and a compression degree can be further improved. In this case, when the second apparatus 20 receives the compressed sequence, the second apparatus 20 may first perform entropy decoding on the compressed sequence to obtain a combined hierarchized sequence. Then, the second apparatus 20 may split each element in the combined hierarchized sequence into a group of a predetermined quantity of elements to obtain an original hierarchized sequence. For example, the second apparatus 20 may split "11" represented as "3" into two elements "1" and "1", to obtain the original hierarchized sequence. Then, the second apparatus 20 may restore, layer by layer from hierarchized sequences at a lowest layer based on the codebook splitting information and the original hierarchized sequence, each first-level sequence and second-level sequence at an upper layer, to finally obtain the original sequence. This manner of combining and splitting elements is known or shared between the first apparatus 10 and the second apparatus 20. This is not limited in this application.

In an example embodiment of this application, when sending the compressed sequence, the first apparatus 10 may further send sequence information associated with the to-be-transmitted sequence corresponding to the compressed sequence. For example, the sequence information may include sequence length information, where the sequence length information may indicate a sequence length of each sequence in the to-be-transmitted sequence. For example, lengths of the five sent sequences in FIG. 5A may respectively be [50, 100, 32, 51, 44]. In addition, when the to-be-transmitted sequence is obtained based on the multi-layer sequence, the sent sequence information may further include sequence position information, where the sequence position information may indicate a layer (to be specific, a layer in the multi-layer sequence) at which each sequence in the to-be-transmitted sequence is located, a position of the sequence at the layer, and a position of a corresponding upper-layer sequence at an upper layer. About examples, refer to FIG. 5A. Sequence position information of the first-level sequence at position 4 at layer 3 may include a layer at which the first-level sequence is located (that is, layer 3), a position of the first-level sequence at the layer (that is, position 4), and a position of the corresponding upper-layer sequence (to be specific, the first-level sequence at position 2 at layer 2) at the upper layer (that is, position 2 at layer 2). In addition, in this application, the position information may alternatively be indicated by using a tree structure or any other feasible manner. This is not limited in this application.

In addition, the sequence information may further include sequence symbol indication information, where the sequence symbol indication information may indicate whether the sequence in the to-be-transmitted sequence is a first-level sequence or a second-level sequence. For example, 0 may indicate a first-level sequence, and 1 may indicate a second-level sequence, or vice versa. Merely as an example, sequence symbol indication of the five sent sequences in FIG. 5A may be [0, 1, 1, 0, 1]. However, in a case in which hierarchized sequences (to be specific, a first-level sequence and a second-level sequence) at each layer are arranged in a preset manner, for example, in a case in which a first-level sequence corresponding to a same upper-layer sequence as a second-level sequence is always arranged on a left or right side of the second-level sequence, because the first-level sequence/second-level sequence is always at an odd or even position, a position of a sequence may indicate whether the sequence is a first-level sequence or a second-level sequence. Therefore, the sequence symbol indication information may be omitted.

In addition, in an example embodiment of this application, the sequence symbol indication information and the sequence length information may also be combined for indication. Still using FIG. 5A as an example, combined indication information may be [(0, 50), (1, 100), (1, 32), (0, 51), (1, 44)]. However, it should be understood that another indication manner is also feasible. This is not limited in this application.

After the to-be-transmitted sequence is determined and entropy-encoded into the compressed sequence as described above, the compressed sequence may be sent as in step S308 in FIG. 3. In an example embodiment of this application, in a case in which an amount of resources (for example, an amount of time-frequency resources) used for data transmission is sufficient, the entire compressed sequence may be sent through one transmission. However, in a case in which the amount of resources (for example, the amount of time-frequency resources) used for data transmission is insufficient, the compressed sequence may be sent through a plurality of transmissions in an incremental transmission manner. In each transmission, a part of the to-be-transmitted sequence to be sent in the current transmission may be determined based on an amount of resources allocated for the current transmission, and then a part that is of the compressed sequence and that is obtained based on the part of the to-be-transmitted sequence (for example, a part of the corresponding compressed sequence obtained by performing entropy encoding on the part of the to-be-transmitted sequence) is sent. In this way, even if the amount of resources allocated for data transmission is insufficient, the to-be-transmitted resource does not need to be further compressed to adapt to the amount of allocated resources, thereby avoiding distortion or losses caused by further compression.

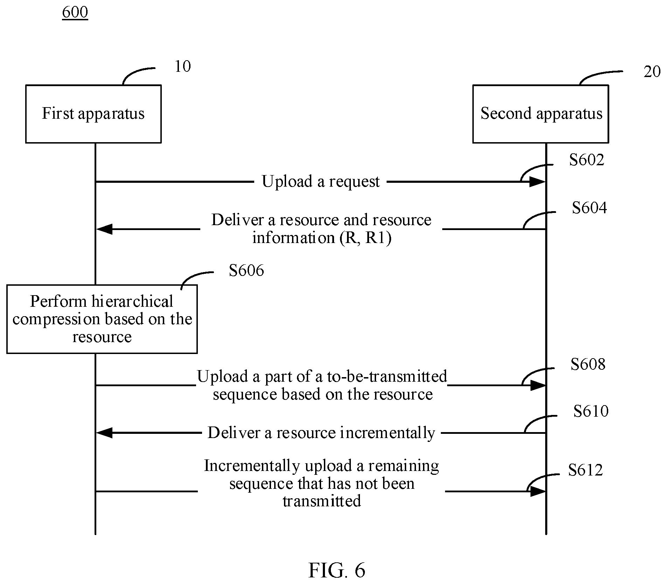

FIG. 6 shows an example flowchart of a method 600 for transmitting a compressed sequence according to an example embodiment of this application. In FIG. 6, it is assumed that a first apparatus 10 (for example, a terminal) sends a to-be-transmitted sequence to a second apparatus 20 (for example, a network device).

As shown in FIG. 6, in step S602, the first apparatus 10 may upload a request to the second apparatus 20 (for example, by using a scheduling request (scheduling request, SR)), to request the second apparatus 20 to allocate a transmission resource. In step S604, the second apparatus 20 may deliver, to the first apparatus 10, a resource allocated for a current transmission. For example, in a 1^{st} transmission, the second apparatus 20 may determine a total resource R required by the first apparatus 10 to upload all data and a resource R₁ that can be allocated to the first apparatus 10 in the 1^{st} transmission, and deliver resource information (R, R₁). Similarly, in a 2^{nd} transmission, the second apparatus 20 may deliver resource information (R, R₂), where R₂ is a resource that can be allocated to the first apparatus 10 in the 2^{nd} transmission. The rest may be deduced by analogy. Optionally, the total required resource R may be sent separately from a resource allocated for each transmission. For example, the total required resource R may be delivered before the 1^{st} transmission, and the resource that can be allocated for each transmission is delivered when each transmission starts. R may be a total amount of resources (for example, R bits) required for achieving a specific indicator (for example, a distortion indicator) and determined based on, for example, a data type or related prior experience (for example, historical information, a size of data of this type uploaded by another apparatus), and the amount of resources should be allocated to the first apparatus 10 to perform quantization to obtain an R-bit original sequence. R₁ is an amount of resources that can be allocated for the current transmission for use due to factors such as a resource limitation. The first apparatus 10 and the second apparatus 20 may implicitly obtain the data type based on information such as a time-frequency resource of the SR. In a possible implementation, new SR types may alternatively be defined to indicate different data types.

In step S606, the first apparatus 10 may perform quantization, hierarchical compression, and the like based on an indication of the second apparatus 20 and the allocated resource. In an example embodiment of this application, merely as an example, the first apparatus 10 may perform, based on the indication of the second apparatus 20, quantization in the quantization steps in FIG. 1 and FIG. 2 by using a quantizer with precision of R, to obtain the R-bit original sequence. In addition, the first apparatus 10 may further perform, based on a hierarchical compression manner (for example, based on codebook splitting information) indicated by the second apparatus 20, hierarchization on the original sequence obtained through quantization, for example, hierarchize the original sequence into one layer of first-level sequence and second-level sequence or a plurality of layers of first-level sequences and second-level sequences.

In step S608, the first apparatus 10 may upload a part of the to-be-transmitted sequence based on the allocated resource (for example, R₁). For example, a part of the first-level sequence and a corresponding part of the second-level sequence may be uploaded.

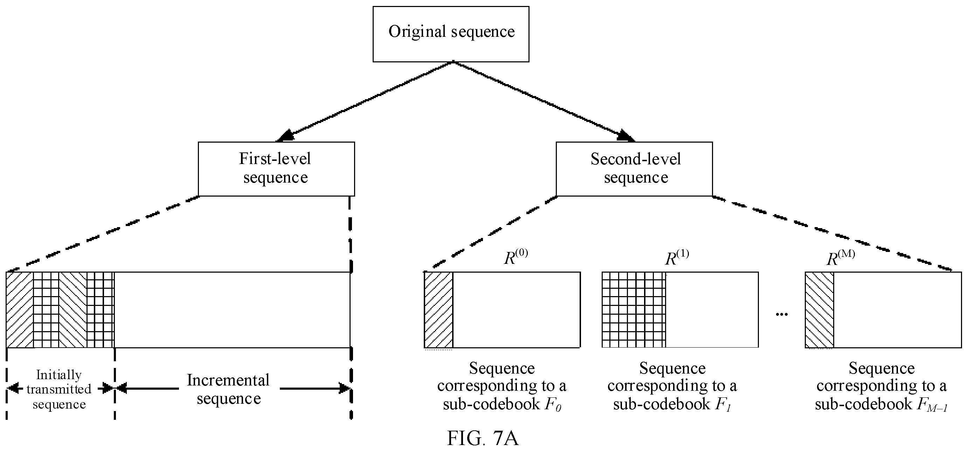

Then, in step S610, the second apparatus 20 may deliver again the resource allocated for the 2^{nd} transmission and resource information (which may be the same as or different from the amount of resources allocated for the previous transmission), and in step S612, the first apparatus 10 may determine, from a remaining unsent sequence based on the resource delivered in step S610, a part of the to-be-transmitted sequence to be sent in a current transmission, and upload the part of the to-be-transmitted sequence. If there is still a remaining part of the to-be-transmitted sequence after step S612, step S610 and step S612 may be repeated until the to-be-transmitted sequence is completely sent. The following describes in detail examples of various example incremental transmission manners with reference to FIG. 7A to FIG. 9C.

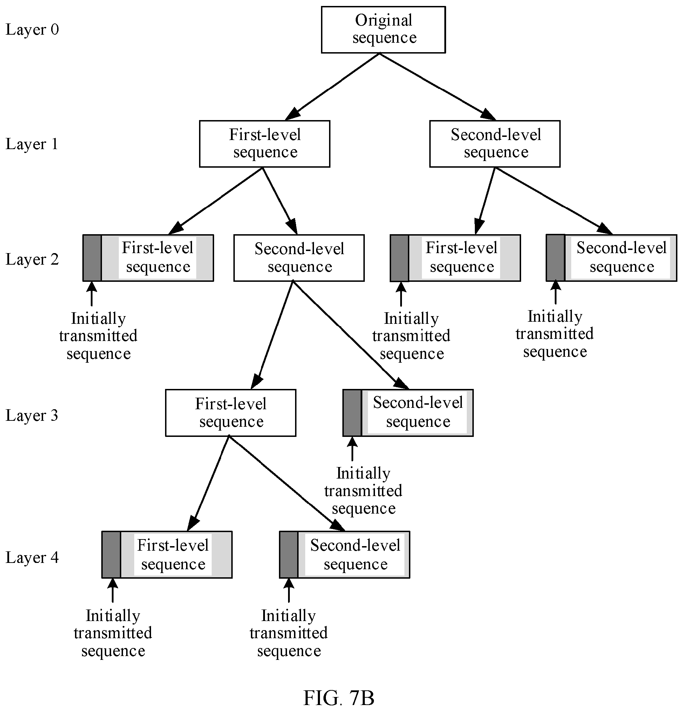

FIG. 7A and FIG. 7B show examples of transmitting a compressed sequence according to example embodiments of this application. FIG. 7A shows an incremental transmission scenario in which an original sequence is hierarchized into hierarchized sequences at a single layer, and FIG. 7B shows an incremental transmission scenario in which an original sequence is hierarchized into hierarchized sequences at a plurality of layers.

In the incremental transmissions shown in FIG. 7A and FIG. 7B, a part of a to-be-transmitted sequence that is determined to be sent in one transmission may include: a part of a first-level sequence in an unsent part of the first-level sequence in the to-be-transmitted sequence and a part of a second-level sequence in an unsent part of the second-level sequence in the to-be-transmitted sequence, where an element in the determined part of the first-level sequence corresponds to an element in the determined part of the second-level sequence, and an amount of resources required for sending the determined part of the first-level sequence and the determined part of the second-level sequence is less than an amount of resources allocated for the current transmission.

Merely as an example, refer to FIG. 7A. The determined part of the to-be-transmitted sequence may be first N elements in the unsent part of the first-level sequence and first N elements in the unsent part of the second-level sequence (N is a positive integer). It can be learned from the foregoing descriptions of hierarchization that, elements at each position (for example, elements at an X^{th} position) in the first-level sequence and the second-level sequence are determined based on an element at a corresponding position (for example, an element at an X^{th} position) in the original sequence. Therefore, there is a correspondence between the elements. In addition, after receiving these elements, the second apparatus 20 may easily restore the corresponding element in the original sequence based on the codebook splitting information. In an example embodiment of this application, as shown in FIG. 7A, these elements may correspond to a same sub-codebook or different sub-codebooks. This is not limited in this application.

Similarly, when the to-be-transmitted sequence is obtained based on a multi-layer sequence, the determined part of the to-be-transmitted sequence in one transmission may be first N elements in an unsent part in each first-level sequence in the to-be-transmitted sequence and first N elements in an unsent part in each second-level sequence in the to-be-transmitted sequence. It can be learned from the foregoing descriptions of hierarchization that elements at a same position in the first-level sequence and the second-level sequence that are obtained from a same sequence through hierarchization are determined based on an element at a corresponding same position in the same sequence. Therefore, there is a correspondence between the elements at the same position in the three sequences. After receiving these elements, the second apparatus 20 may easily restore, layer by layer based on the codebook splitting information, a corresponding element in a corresponding sequence at an upper layer, until a corresponding element in the original sequence is restored.

In addition, in an example embodiment of this application, in the increment transmission scenario with hierarchized sequences at a single layer in FIG. 7A, when sending the part that is of the compressed sequence and that is obtained based on the determined part of the to-be-transmitted sequence, the first apparatus 10 may further send sequence information associated with the determined part of the to-be-transmitted sequence. For example, the sequence information may include sequence symbol indication information indicating whether a sequence to which the part of the to-be-transmitted sequence belongs is a first-level sequence or a second-level sequence, so that the second apparatus 10 that receives the part of sequence can distinguish whether the received part of sequence is a first-level sequence or a second-level sequence, and therefore can use a corresponding sub-codebook to restore a corresponding part of the original sequence. In addition, optionally, the sequence information may further include a sequence length of the part of the to-be-transmitted sequence, for example, a length of each determined part of the first-level sequence or the second-level sequence.

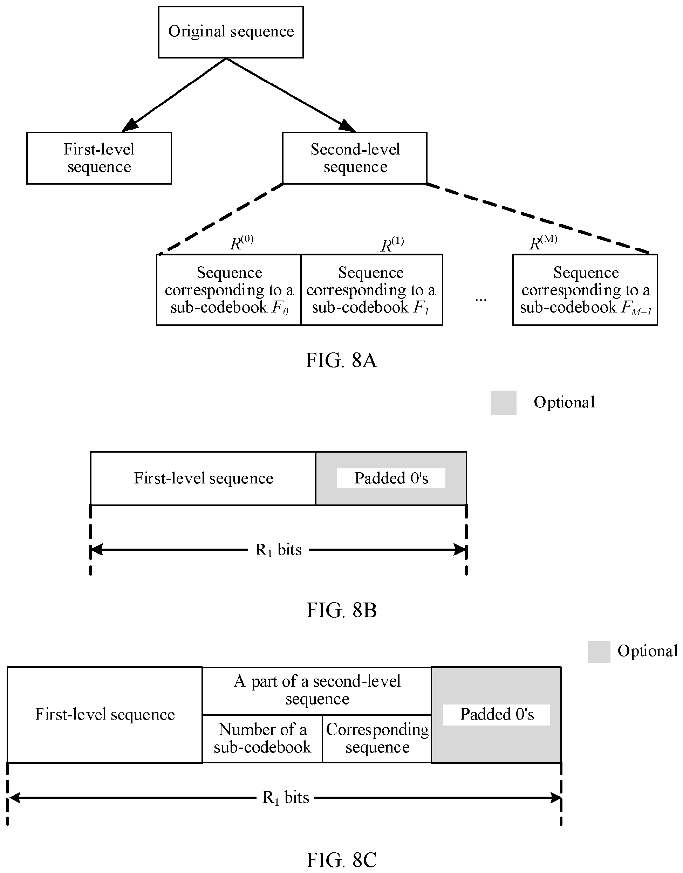

In addition, in an example embodiment of this application, in the increment transmission scenario with hierarchized sequences at a plurality of layers in FIG. 7B, when sending the part that is of the compressed sequence and that is obtained based on the determined part of the to-be-transmitted sequence, the sequence information sent by the first apparatus 10 may not only include the foregoing sequence symbol indication information, but also include sequence position information of each sequence to which the part of the to-be-transmitted sequence belongs, so that the second apparatus 10 that receives the part of the to-be-transmitted sequence can use a corresponding sub-codebook to restore the corresponding part of the original sequence level by level. FIG. 8A to FIG. 8C show other examples of transmitting a compressed sequence according to example embodiments of this application.

In the examples shown in FIG. 8A to FIG. 8C, the first apparatus 10 may first transmit the first-level sequence, and then transmit the second-level sequence after the first-level sequence is completely transmitted; or may first transmit the second-level sequence, and then transmit the first-level sequence after the second-level sequence is completely transmitted. This is not limited in this application.

In an example embodiment of this application, when determining a part of the to-be-transmitted sequence to be sent in each transmission, the first apparatus 10 may first determine whether an unsent first-type sequence (namely, a sequence that is determined to be preferentially sent) exists. The first-type sequence may be a first-level sequence or a second-level sequence. This is not limited herein. If it is determined that the unsent first-type sequence exists, the first apparatus 10 may determine whether the amount of resources allocated for the current transmission is sufficient to send the unsent first-type sequence. If the amount of resources allocated for the current transmission is insufficient to send the unsent first-type sequence, the first apparatus 10 may select at least one first-type sub-sequence from the unsent first-type sequence as the part of the to-be-transmitted sequence to be sent in the current transmission. The sub-sequence may be a sequence formed by some elements in the first-type sequence. An amount of resources required for sending the selected at least one first-type sub-sequence should be less than the amount of allocated resources. In addition, if the amount of resources allocated for the current transmission is sufficient to send the unsent first-type sequence, the first apparatus 10 may determine the unsent first-type sequence as the part of the to-be-transmitted sequence to be sent in the current transmission.

In an example embodiment of this application, optionally, when selecting the at least one first-type sub-sequence from the unsent first-type sequence, the first apparatus 10 may select the at least one first-type sub-sequence based on a sub-codebook corresponding to the unsent first-type sequence. Merely as an example, as shown in FIG. 8A, it is assumed that the second-level sequence is the foregoing unsent first-type sequence. In this case, a sub-sequence formed by elements corresponding to at least one of sub-codebooks F₀, F₁, ..., and F_{M-1} that correspond to the second-level sequence may be selected as at least one second-level sub-sequence to be sent (an amount of required resources should be less than the amount of allocated resources). For example, a sub-sequence *R*⁽⁰⁾ formed by elements corresponding to the sub-codebook F₀ may be selected as the at least one second-level sub-sequence to be sent. In addition, if the amount of resources allocated for the current transmission is sufficient to send the unsent first-type sequence, the first apparatus 10 may further determine an amount of remaining available resources based on the amount of resources allocated for the current transmission and an amount of resources used to send the unsent first-type sequence. If the amount of remaining available resources is sufficient to send the at least one second-type sub-sequence of the unsent second-type sequence, the first apparatus 10 may determine that the part of the to-be-transmitted sequence to be sent in the current transmission may further include the at least one second-type sub-sequence. The second-type sequence is a sequence different from the first-type sequence in the first-level sequence and the second-level sequence. Optionally, the first apparatus 10 may select the at least one second-type sub-sequence based on a sub-codebook corresponding to the unsent second-type sequence. In this case, when sending the part that is of the compressed sequence and that is obtained based on the determined part of the to-be-transmitted sequence, the first apparatus 10 may further send a number of a sub-codebook corresponding to each second-type sub-sequence in the selected at least one second-type sub-sequence.

FIG. 8B and FIG. 8C explain, by using an example in which the to-be-transmitted sequence is sent through two transmissions, incremental transmission according to example embodiments of this application. Merely as an example, as shown in FIG. 8B, all first-level sequences may be transmitted in a 1^{st} transmission (that is, initial transmission), and second-level sequences are transmitted in a 2^{nd} transmission (that is, incremental transmission). Optionally, as shown in FIG. 8C, all first-level sequences and a part of second-level sequences may be transmitted in a 1^{st} transmission (that is, initial transmission), and a remaining second-level sequence that is not transmitted may be transmitted in a 2^{nd} transmission (that is, incremental transmission).

In an example embodiment of this application, whether to perform transmission in the manner shown in FIG. 8B or FIG. 8C may be determined based on compressed lengths (namely, lengths after entropy encoding) of sequences corresponding to different sub-codebooks in the first-level sequence or the second-level sequence.

Merely as an example, the first-level sequence is transmitted first. It is assumed that a length after entropy encoding of the first-level sequence is L₁ and an amount of resources allocated for the current transmission is R₁ bits. If L₁≤R₁ and R₁-L₁≤R⁽ⁱ⁾ (as shown in FIG. 8A, R⁽ⁱ⁾ is a length after entropy encoding of a sub-sequence corresponding to a sub-codebook 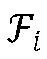 in the second-level sequence, and *i* ∈ [0, *M* - 1] ), in other words, an amount of resources remaining after sending the first-level sequence is insufficient to send a sub-sequence corresponding to any sub-codebook in the second-level sequence, the first apparatus 10 may perform zero padding on the first-level sequence after entropy encoding to R₁ for sending, as shown in FIG. 8B. Optionally, the first apparatus 10 may not need to perform zero padding, but may send only the first-level sequence during the initial transmission.

In addition, if L₁≤R₁ and there is at least one second-level sub-sequence whose length R⁽ⁱ⁾ after entropy encoding satisfies ∑*R*^{(*i*)} ≤ *R*₁ - *L*₁, the at least one second-level sub-sequence may be further sent during the initial transmission. In addition, to enable the second apparatus 20 to identify the received at least one second-level sub-sequence, as shown in FIG. 8C, the first apparatus 10 may further send, during the initial transmission, a number of a sub-codebook corresponding to the at least one second-level sub-sequence. In addition, if the length after entropy encoding of the first-level sequence and the at least one second-level sub-sequence is still less than R₁, as shown in FIG. 8C, the first apparatus 10 may perform zero padding on the first-level sequence after entropy encoding and the at least one second-level sub-sequence after entropy encoding to R₁ for sending. Optionally, zero padding may not need to be performed.

In addition, in an example embodiment of this application, when a plurality of layers of first-level sequences and second-level sequences are transmitted in the manner in FIG. 8A to FIG. 8C, the first apparatus 10 may further send, in each transmission, sequence position information corresponding to the determined part of the to-be-transmitted sequence. For example, in the scenario in FIG. 8B, the first apparatus 10 may further send, during the initial transmission, sequence position information corresponding to each first-level sequence. For another example, in the scenario in FIG. 8C, the first apparatus 10 may further send, during the initial transmission, sequence position information corresponding to each first-level sequence and sequence position information of the selected at least one second-level sub-sequence in the second-level sequence.

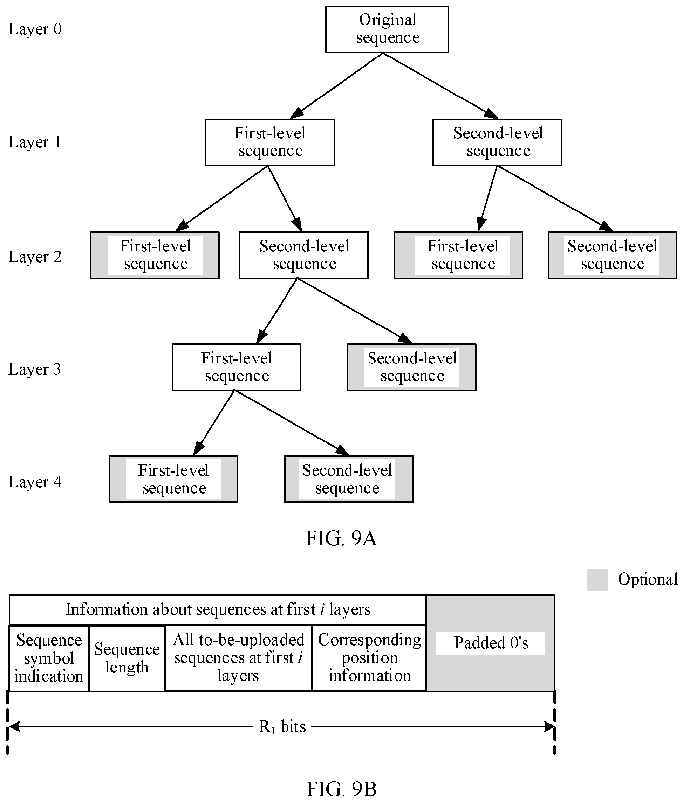

FIG. 9A to FIG. 9C show other examples of transmitting a compressed sequence according to example embodiments of this application. The examples shown in FIG. 9A to FIG. 9C are for a scenario in which the to-be-transmitted sequence is obtained based on a multi-layer sequence.

In the examples shown in FIG. 9A to FIG. 9C, in each transmission, the first apparatus 10 may determine, based on an order of layers from high to low at which unsent to-be-transmitted sequences are located in the multi-layer sequence, as the part of the to-be-transmitted sequence to be sent in the current transmission, a sequence at a layer (for example, a highest layer) that can be sent by using the amount of resources allocated for the current transmission.

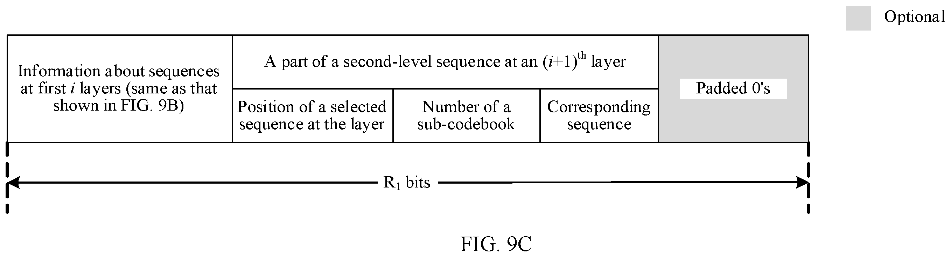

For example, refer to FIG. 9A. The first apparatus 10 may start from a current highest layer in one or more layers of to-be-transmitted sequences (for example, if the current transmission is a 1^{st} transmission, the current highest layer may be layer 2 shown in FIG. 9; and if the current transmission is a 2^{nd} transmission, and to-be-transmitted sequences at layer 2 and layer 3 have been sent in the 1^{st} transmission, the current highest layer may be layer 4 shown in FIG. 9), and determine whether a length after entropy encoding of a to-be-transmitted sequence at the layer is less than the amount R₁ of resources allocated for the current transmission. If the length after entropy encoding of the to-be-transmitted sequence at the layer is less than the amount of resources allocated for the current transmission, the process proceeds to a lower layer, and it is determined whether a total length after entropy encoding of to-be-transmitted sequences at the current highest layer and the lower layer is less than the amount R₁ of resources allocated for the current transmission. The rest may be deduced by analogy until it is determined that a total length after entropy encoding of to-be-transmitted sequences at first i+1 layers is greater than R₁ at an (i+1)^{th} layer. In this case, a length after entropy encoding of to-be-transmitted sequences at first i layers is less than R₁. The first apparatus 10 may send, based on the amount of allocated resources, a compressed sequence obtained based on the to-be-transmitted sequences at the first i layers (for example, obtained through entropy encoding). In addition, when sending the compressed sequence obtained based on the to-be-transmitted sequences at the first i layers, the first apparatus 10 may further send sequence symbol indication information (optional), sequence length information, and sequence position information of each sequence in the to-be-transmitted sequences at the first i layers.

In addition, in an example embodiment of this application, the first apparatus 10 may further determine an amount of remaining available resources based on the amount R₁ of resources allocated for the current transmission and an amount of resources actually used for sending the compressed sequence obtained based on to-be-transmitted sequences at the first i layers. If the amount of remaining available resources is sufficient to send at least one sub-sequence of a to-be-transmitted sequence at the (i+1)^{th} layer (for example, the amount of remaining available resources is greater than *R*^{(*i*+1,*j*,*k*)}, and *R*^{(i+1,j,*k*)} is a length after entropy encoding of a sub-sequence that corresponds to any sub-codebook *k* and that is of a *j*^{th} second-level sequence from left to right at the *i* _{+ 1}^{th} layer), the first apparatus 10 may further send, in the current transmission, a corresponding compressed sequence of the at least one sub-sequence of the to-be-transmitted sequence at the (i+1)^{th} layer. In an example embodiment of this application, the first apparatus 10 may select the at least one sub-sequence of the to-be-transmitted sequence at the (i+1)^{th} layer based on a sub-codebook, as shown in the examples in FIG. 8B and FIG. 8C. In addition, if the at least one sub-sequence belongs to a second-level sequence, in the current transmission, the first apparatus 10 may further send a number of a corresponding sub-codebook of the at least one sub-sequence and a position that is of the second-level sequence to which the at least one sub-sequence belongs and that is at the (i+1)^{th} layer. If the at least one sub-sequence belongs to a first-level sequence, in the current transmission, the first apparatus 10 may further send a position that is of the first-level sequence to which the at least one sub-sequence belongs and that is at the (i+1)^{th} layer.

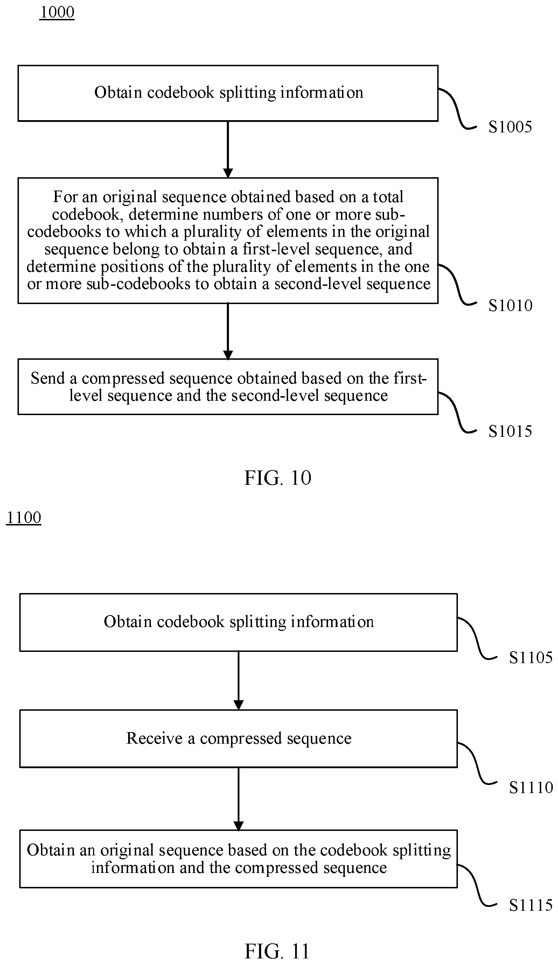

FIG. 10 shows a flowchart of a method 1000 for sending compressed data according to an example embodiment of this application. In a possible implementation, the method 1000 may be implemented by the first apparatus 10 in FIG. 3. In another possible implementation, the method 1000 may alternatively be implemented by another electronic apparatus. As an example, the following describes the method 1000 by using an example in which the method 1000 is implemented by the first apparatus 10 in FIG. 3.

In step S1005, the first apparatus 10 may obtain codebook splitting information, where the codebook splitting information indicates to split an overall codebook into a plurality of sub-codebooks. In step S1010, the first apparatus 10 may obtain a first-level sequence and a second-level sequence for an original sequence obtained based on the overall codebook. The first-level sequence may include a number of a sub-codebook, among the plurality of sub-codebooks, to which each element in the original sequence belongs, and the second-level sequence may include a position of the element in the sub-codebook to which the element belongs. In step S1015, the first apparatus 10 may send a compressed sequence obtained based on the first-level sequence and the second-level sequence.

The foregoing has described in detail specific operations of steps of the first apparatus 10 with reference to FIG. 3 to FIG. 9. For brevity, details are not described herein again.

FIG. 11 shows a flowchart of a method 1100 for receiving compressed data according to an example embodiment of this application. In a possible implementation, the method 1100 may be implemented by the second apparatus 20 in FIG. 3. In another possible implementation, the method 1100 may alternatively be implemented by another electronic apparatus. As an example, the following describes the method 1100 by using an example in which the method 1100 is implemented by the second apparatus 20 in FIG. 3.

In step S1105, the second apparatus 20 may obtain codebook splitting information, where the codebook splitting information may indicate to split an overall codebook into a plurality of sub-codebooks. In step S1110, the second apparatus 20 may receive a compressed sequence, where the compressed sequence may be generated by the first apparatus 10 based on a first-level sequence and a second-level sequence, the first-level sequence may include a number of a sub-codebook, among the plurality of sub-codebooks, to which each element in an original sequence belongs, and the second-level sequence may include a position of the element in the sub-codebook to which the element belongs. For example, the first-level sequence may be generated by the first apparatus 10 in the following manner: determining numbers of one or more sub-codebooks, among the plurality of sub-codebooks, to which a plurality of elements in the original sequence belong, and the second-level sequence may be generated by the first apparatus 10 in the following manner: determining positions of the plurality of elements in the one or more sub-codebooks. The original sequence may be generated based on the overall codebook. In step S1115, the second apparatus 20 may obtain the original sequence based on the codebook splitting information and the compressed sequence.

The foregoing has described in detail specific operations of steps of the second apparatus 20 with reference to FIG. 3 to FIG. 9. For brevity, details are not described herein again.

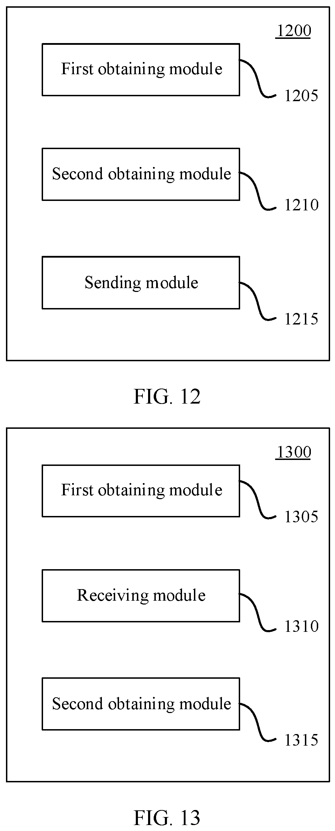

FIG. 12 shows a block diagram of an apparatus 1200 that sends compressed data according to an example embodiment of this application. In a possible implementation, the apparatus 1200 may correspond to the first apparatus 10 in FIG. 3. In another possible implementation, the apparatus 1200 may alternatively be implemented by another electronic apparatus.

Refer to FIG. 12. The apparatus 1200 includes a first obtaining module 1205, a second obtaining module 1210, and a sending module 1215. A composition manner of the apparatus 1200 shown in FIG. 12 is merely an example. This application is not limited thereto. The apparatus 1200 may alternatively have another structure and another module division manner, provided that the operations described herein can be implemented. Merely as an example, although not shown, the apparatus 1200 may include a transceiver module and a processing module. The transceiver module may be configured to implement a function of the sending module 1215, and the processing module may be configured to implement functions of the first obtaining module 1205 and the second obtaining module 1210.

In some embodiments of this application, the first obtaining module 1205 may obtain codebook splitting information. The codebook splitting information may indicate to split an overall codebook into a plurality of sub-codebooks. The second obtaining module 1210 may obtain a first-level sequence and a second-level sequence for an original sequence obtained based on the overall codebook. The first-level sequence may include a number of a sub-codebook, among the plurality of sub-codebooks, to which each element in the original sequence belongs, and the second-level sequence may include a position of the element in the sub-codebook to which the element belongs. The sending module 1215 may send a compressed sequence obtained based on the first-level sequence and the second-level sequence. In addition, although not shown, the apparatus 1200 may further include an entropy encoding module (not shown) and the like, configured to perform operations such as entropy encoding on a to-be-sent sequence to obtain a compressed sequence.

The foregoing has described in detail specific functions and operations of the modules of the apparatus 1200 with reference to FIG. 3 to FIG. 9. For brevity, details are not described herein again.

FIG. 13 shows a block diagram of an apparatus 1300 that receives compressed data according to an example embodiment of this application. In a possible implementation, the apparatus 1300 may correspond to the second apparatus 20 in FIG. 3. In another possible implementation, the apparatus 1300 may alternatively be implemented by another electronic apparatus.

Refer to FIG. 13. The apparatus 1300 may include a first obtaining module 1305, a receiving module 1310, and a second obtaining module 1315.

In some embodiments of this application, the first obtaining module 1305 may obtain codebook splitting information, where the codebook splitting information may indicate to split an overall codebook into a plurality of sub-codebooks. The receiving module 1310 may receive a compressed sequence from, for example, the apparatus 1200, where the compressed sequence may be generated based on a first-level sequence and a second-level sequence, the first-level sequence may include a number of a sub-codebook, among the plurality of sub-codebooks, to which each element in an original sequence belongs, and the second-level sequence may include a position of the element in the sub-codebook to which the element belongs. The original sequence may be generated based on the overall codebook. The second obtaining module 1315 may obtain the original sequence based on the codebook splitting information and the compressed sequence. In addition, although not shown, the apparatus 1300 may further include an entropy decoding module (not shown) and the like, configured to perform operations such as entropy decoding on the received compressed sequence.

The foregoing has described in detail specific functions and operations of the modules of the apparatus 1300 with reference to FIG. 3 to FIG. 9. For brevity, details are not described herein again.

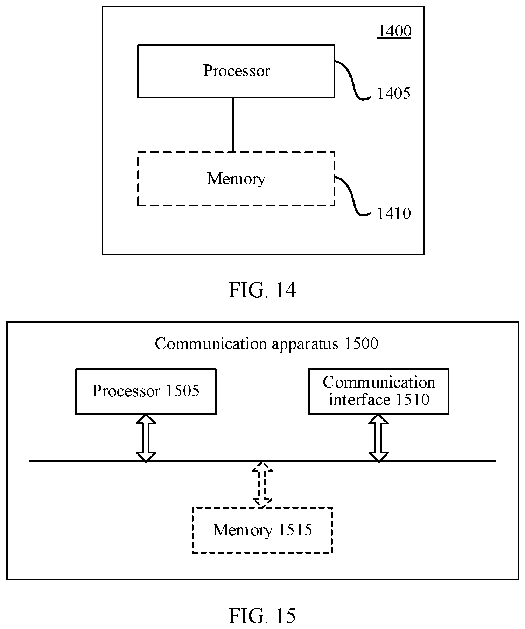

FIG. 14 is a diagram of a structure of an example electronic device 1400 that can implement embodiments of this application. The electronic device 1400 may implement functions of the apparatus that sends compressed data and the apparatus that receives compressed data in the foregoing method embodiments.

As shown in FIG. 14, the electronic device 1400 may include a processor 1405. The processor 1405 may enable, by executing a computer program (or computer-executable instructions) stored in the memory and/or by using a logic circuit, the electronic device 1400 to perform the operations of the first apparatus 10 (or the apparatus 1200) or the second apparatus 20 (or the apparatus 1300) described above. In addition, optionally, the electronic device 1400 may further include a memory 1410 (optional) to store instructions. When the instructions are executed by the processor 1405, the electronic device 1400 is caused to perform the operations of the first apparatus 10 (or the apparatus 1200) or the second apparatus 20 (or the apparatus 1300) described above. The processor 1405 and the memory 1410 may be integrated, or the memory 1410 may be located outside the electronic device.

FIG. 15 is a diagram of a structure of an example communication apparatus 1500 that can implement embodiments of this application. As shown in FIG. 15, the communication apparatus 1500 may include a processor 1505 and a communication interface 1510. The processor 1505 and the interface circuit 1510 may be coupled to each other. It may be understood that the communication interface 1510 may be a transceiver, an input/output interface, or various physical or virtual interfaces defined in a communication protocol. Optionally, the communication apparatus 1500 may further include a memory 1515, configured to store instructions executed by the processor 1505, or store input data required by the processor 1505 to execute the instructions, or store data generated after the processor 1505 executes the instructions.

When the communication apparatus 1500 is configured to implement the methods in the foregoing method embodiments, the processor 1505 and the communication interface 1510 may work together (for example, using the communication interface 1510) to implement the operations of the first apparatus 10 (or the apparatus 1200) or the second apparatus 20 (or the apparatus 1300) described above.

An embodiment of this application further provides a communication system. The communication system may include any apparatus in the embodiments shown in FIG. 3 to FIG. 13. Optionally, the apparatus in the communication system may perform the method shown in any one of FIG. 3 to FIG. 13.

It should be understood that the processor mentioned in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It should be further understood that the memory mentioned in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example, and not limitation, many forms of RAMs are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), a compact disc read-only memory (compact disc read-only memory, CD-ROM), and a direct rambus random access memory (direct rambus RAM, DR RAM).

It should be noted that when the processor is a general-purpose processor, a DSP, an ASIC, an FPGA or another programmable logic device, a discrete gate or a transistor logic device, or a discrete hardware component, the memory (a storage module) is integrated into the processor.

It should be noted that the memory described in this specification is intended to include but is not limited to these memories and any memory of another appropriate type.

It should be understood that sequence numbers of the foregoing processes do not mean execution sequences in various embodiments of this application. The execution sequences of the processes should be determined based on functions and internal logic of the processes, and should not constitute any limitation on implementation processes of embodiments of this application.

A person of ordinary skill in the art may be aware that, the modules and algorithm steps in the examples described with reference to embodiments disclosed in this specification can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed method and apparatus may be implemented in other manners. For example, the described apparatus embodiment is merely an example. For example, division into the modules is merely logical function division and there may be other division manners in actual implementation. For example, a plurality of modules or components may be combined or integrated into another system, or some features may be ignored or not performed. In addition, the displayed or described mutual couplings or direct couplings or communication connections may be implemented through some interfaces. The indirect couplings or communication connections between the apparatuses or the units may be implemented in electronic, mechanical, or other forms.

The modules described as separate parts may or may not be physically separate, and parts displayed as modules may or may not be physical modules, may be located in one position, or may be distributed on a plurality of network units. Some or all of the units may be selected based on actual requirements to achieve the objectives of the solutions of embodiments.

In addition, functional modules in embodiments of this application may be integrated into one processing module, or each of the modules may exist alone physically, or two or more modules may be integrated into one module.

When the functions are implemented in a form of a software functional module and sold or used as an independent product, the functions may be stored in a computer-readable storage medium. Based on such an understanding, the technical solutions of this application essentially, or a part contributing to the technical solutions, or some of the technical solutions may be implemented in a form of a software product. The computer software product is stored in a storage medium and includes several instructions for instructing a computer device (which may be a personal computer, a server, a network device, or the like) to perform all or some of the steps of the methods in embodiments of this application. The foregoing computer-readable storage medium may be any usable medium that can be accessed by a computer. For example, but not limited to, the computer-readable medium may include a RAM, a ROM, an EEPROM, a CD-ROM, a universal serial bus flash disk (universal serial bus flash disk), a removable hard disk or another optical disc storage, a magnetic disk storage medium or another magnetic storage device, or any other medium that can be used to carry or store expected program code in a form of instructions or a data structure and that can be accessed by the computer.

As used in this specification, the term "including" and similar terms should be understood as open inclusion, that is, "including but not limited to". The term "based on" should be understood as "at least partially based on". The term "one embodiment" or "this embodiment" should be understood as "at least one embodiment". The terms such as "first", "second", and the like may refer to different objects or a same object, and are only used to distinguish between specified objects, but do not imply a specific spatial order, a time order, an importance order, or the like of the specified objects. In some embodiments, a value, a process, a selected item, a determined item, a device, an apparatus, a means, a part, a component, or the like is referred to as "optimal", "lowest", "highest", "minimum", "maximum", or the like. It should be understood that such a description is intended to indicate that a selection may be made among many available functional selections, and that such a selection does not need to be better, lower, higher, smaller, larger, or otherwise preferred than other selections in other aspects or in all aspects. As used in this specification, the term "determining" may cover a variety of actions. For example, "determining" may include operating, calculation, processing, export, investigation, lookup (for example, lookup in a table, a database, or another data structure), finding, and the like. In addition, "determining" may include receiving (for example, receiving information), accessing (for example, accessing data in a memory), and the like. In addition, "determining" may include parsing, selecting, choosing, establishing, and the like.

The foregoing descriptions are merely specific implementations of this application, but the protection scope of embodiments of this application is not limited thereto. Any variation or replacement readily figured out by a person skilled in the art within the technical scope disclosed in embodiments of this application shall fall within the protection scope of embodiments of this application. Therefore, the protection scope of embodiments of this application should be subject to the protection scope of the claims.

## Claims

1. A method, comprising:
obtaining codebook splitting information, wherein the codebook splitting information indicates to split an overall codebook into a plurality of sub-codebooks;
obtaining a first-level sequence and a second-level sequence for an original sequence obtained based on the overall codebook, wherein the first-level sequence comprises a number of a sub-codebook, among the plurality of sub-codebooks, to which each element in the original sequence belongs, and the second-level sequence comprises a position of the element in the sub-codebook to which the element belongs; and
sending a compressed sequence obtained based on the first-level sequence and the second-level sequence.

2. The method according to claim 1, further comprising: determining, based on the first-level sequence and the second-level sequence, a to-be-transmitted sequence corresponding to the original sequence, wherein
the compressed sequence is obtained based on the to-be-transmitted sequence.

3. The method according to claim 2, wherein the to-be-transmitted sequence is obtained based on a multi-layer sequence, the first-level sequence is a first-level sequence at layer 1 in the multi-layer sequence, the second-level sequence is a second-level sequence at layer 1 in the multi-layer sequence, the sub-codebook is a layer-1 sub-codebook, and the multi-layer sequence is generated in the following manner:
determining a to-be-hierarchized sequence among sequences at layer 1;
obtaining a first-level sequence at layer 2 and a second-level sequence at layer 2 based on the to-be-hierarchized sequence at layer 1, wherein the first-level sequence at layer 2 comprises a number of a layer-2 sub-codebook, among the plurality of sub-codebooks, to which each element in the to-be-hierarchized sequence at layer 1 belongs, and the second-level sequence at layer 2 comprises a position of the element in the layer-2 sub-codebook to which the element belongs.

4. The method according to claim 2, wherein the to-be-transmitted sequence comprises the first-level sequence and the second-level sequence, and the compressed sequence is obtained in the following manners:
separately performing entropy encoding on the first-level sequence and the second-level sequence; or
performing entropy encoding on the first-level sequence and the second-level sequence together.

5. The method according to claim 3, wherein determining the to-be-transmitted sequence comprises:
determining, as the to-be-transmitted sequence, at least one of the first-level sequence and the second-level sequence in the multi-layer sequence that are determined as not belonging to the to-be-hierarchized sequence, wherein the compressed sequence is obtained in the following manners:
separately performing entropy encoding on the first-level sequence and the second-level sequence in the to-be-transmitted sequence; or
performing entropy encoding on the first-level sequence and the second-level sequence in the to-be-transmitted sequence together.

6. The method according to claim 5, wherein performing entropy encoding on the second-level sequence comprises:
separately performing entropy encoding on a plurality of sequences in the second-level sequence that belong to different sub-codebooks.

7. The method according to claim 2 or 3, wherein sending the compressed sequence further comprises: sending sequence information associated with the to-be-transmitted sequence, wherein
the sequence information comprises:
sequence length information, indicating a sequence length of the to-be-transmitted sequence.

8. The method according to claim 7, wherein when the to-be-transmitted sequence is obtained based on the multi-layer sequence, the sequence information further comprises:
sequence position information, indicating a layer at which a sequence in the to-be-transmitted sequence is located, a position of the sequence at the layer, and a position of a corresponding upper-layer sequence at an upper layer.

9. The method according to claim 7 or 8, wherein the sequence information further comprises:
sequence symbol indication information, indicating whether the sequence in the to-be-transmitted sequence is a first-level sequence or a second-level sequence.

10. The method according to any one of claims 7 to 9, wherein sending the compressed sequence comprises: sending the compressed sequence through a plurality of transmissions, wherein one of the plurality of transmissions comprises:
determining, based on an amount of resources allocated for a current transmission, a part of the to-be-transmitted sequence to be sent in the current transmission; and
sending a part that is of the compressed sequence and that is obtained based on the part of the to-be-transmitted sequence.

11. The method according to claim 10, wherein the part of the to-be-transmitted sequence comprises: a part of the first-level sequence in an unsent part of the first-level sequence in the to-be-transmitted sequence and a part of the second-level sequence in an unsent part of the second-level sequence in the to-be-transmitted sequence, wherein
an element in the part of the first-level sequence corresponds to an element in the part of the second-level sequence; and
an amount of resources required for sending the part of the first-level sequence and the part of the second-level sequence is less than the amount of allocated resources.

12. The method according to claim 11, wherein sending the part that is of the compressed sequence and that is obtained based on the part of the to-be-transmitted sequence further comprises: sending sequence information associated with the part of the to-be-transmitted sequence, wherein
the sequence information associated with the part of the to-be-transmitted sequence comprises sequence symbol indication information indicating whether a sequence to which the part of the to-be-transmitted sequence belongs is a first-level sequence or a second-level sequence.

13. The method according to claim 12, wherein when the to-be-transmitted sequence is obtained based on the multi-layer sequence, the sequence information associated with the part of the to-be-transmitted sequence further comprises sequence position information of the sequence to which the part of the to-be-transmitted sequence belongs.

14. The method according to claim 10, wherein determining the part of the to-be-transmitted sequence to be sent in the current transmission comprises:
determining whether an unsent first-type sequence exists, wherein the first-type sequence comprises a first-level sequence or a second-level sequence; and
based on determining that the unsent first-type sequence exists:
determining whether the amount of resources allocated for the current transmission is sufficient to send the unsent first-type sequence; and
in response to the amount of resources allocated for the current transmission being insufficient to send the unsent first-type sequence, selecting at least one first-type sub-sequence from the unsent first-type sequence as the part of the to-be-transmitted sequence to be sent in the current transmission, wherein an amount of resources required for sending the selected at least one first-type sub-sequence is less than the amount of allocated resources; or
in response to the resources allocated for the current transmission being sufficient to send the unsent first-type sequence, determining the unsent first-type sequence as the part of the to-be-transmitted sequence to be sent in the current transmission.

15. The method according to claim 14, wherein selecting the at least one first-type sub-sequence from the unsent first-type sequence comprises:
selecting the at least one first-type sub-sequence based on a sub-codebook corresponding to the unsent first-type sequence.

16. The method according to claim 14, wherein when the amount of resources allocated for the current transmission is sufficient to send the unsent first-type sequence, determining the part of the to-be-transmitted sequence to be sent in the current transmission comprises:
determining an amount of remaining available resources based on the amount of resources allocated for the current transmission and an amount of resources used to send the unsent first-type sequence, wherein
in response to the amount of remaining available resources being sufficient to send at least one second-type sub-sequence of the unsent second-type sequence, the part of the to-be-transmitted sequence further comprises the at least one second-type sub-sequence, wherein the second-type sequence is a sequence different from the first-type sequence in the first-level sequence and the second-level sequence.

17. The method according to claim 16, wherein the at least one second-type sub-sequence is determined based on a sub-codebook corresponding to the unsent second-type sequence, and sending the part of the compressed sequence further comprises:
sending a number of a sub-codebook corresponding to a second-type sub-sequence in the at least one second-type sub-sequence.

18. The method according to claim 10, wherein when the to-be-transmitted sequence is obtained based on the multi-layer sequence, determining the part of the to-be-transmitted sequence to be sent in the current transmission comprises:
based on an order of layers from high to low at which unsent to-be-transmitted sequences are located in the multi-layer sequence, determining, as the part of the to-be-transmitted sequence to be sent in the current transmission, sequences of a quantity of layers that are transmittable by using the amount of resources allocated for the current transmission.

19. The method according to claim 18, wherein sending the part of the compressed sequence further comprises:
sending sequence symbol indication information, sequence length information, and sequence position information of a sequence in the part of the to-be-transmitted sequence.

20. The method according to claim 18, wherein determining the part of the to-be-transmitted sequence to be sent in the current transmission further comprises:
determining an amount of remaining available resources based on the amount of resources allocated for the current transmission and an amount of resources used to send the sequences of the quantity of layers, wherein
in response to the amount of remaining available resources being sufficient to send at least one sub-sequence of a sequence at a layer lower than the sequences of the quantity of layers, the part of the to-be-transmitted sequence further comprises the at least one sub-sequence, wherein the at least one sub-sequence comprises at least one sub-sequence of a first-level sequence or a second-level sequence at the lower layer.

21. The method according to claim 20, wherein the at least one sub-sequence is determined based on a sub-codebook corresponding to the first-level sequence or the second-level sequence at the lower layer, and if the at least one sub-sequence is at least one sub-sequence of the second-level sequence, sending the part of the compressed sequence further comprises:
sending a number of a sub-codebook corresponding to a sub-sequence in the at least one sub-sequence and a position that is of a sequence to which the at least one sub-sequence belongs and that is at the lower layer.

22. The method according to any one of claims 3 to 18, wherein determining the to-be-hierarchized sequence in the sequences at layer 1 comprises:
performing entropy encoding on a first-level sequence and a second-level sequence that are at layer 2 and that correspond to each of the sequences at layer 1, to obtain a first length corresponding to an encoded sequence;
performing entropy encoding on the sequences at layer 1, to obtain second lengths corresponding to encoded sequences; and
determining a sequence that is at layer 1 and whose first length is less than the second length as the to-be-hierarchized sequence.

23. The method according to claim 22, wherein before determining the to-be-hierarchized sequence in the sequences at layer 1, the method further comprises:
determining whether layer 1 has reached a quantity of layers of the multi-layer sequence; and
determining, based on determining that layer 1 has reached the quantity of layers, that no to-be-hierarchized sequence exists; or
determining, based on determining that layer 1 has not reached the quantity of layers, the to-be-hierarchized sequence in the sequences at layer 1.

24. The method according to claim 18, wherein sending the compressed sequence further comprises:
combining, by using a preset quantity of elements as a group, a plurality of adjacent elements in the to-be-transmitted sequence as a single element, to obtain a combined to-be-transmitted sequence; and
sending a compressed sequence obtained based on the combined to-be-transmitted sequence.

25. The method according to any one of claims 1 to 24, wherein the codebook splitting information is obtained in one of the following manners:
pre-configured;
determined by an apparatus that sends the compressed sequence; or
received from an apparatus that receives the compressed sequence.

26. A method, comprising:
obtaining codebook splitting information, wherein the codebook splitting information indicates to split an overall codebook into a plurality of sub-codebooks;
receiving a compressed sequence, wherein the compressed sequence is generated based on a first-level sequence and a second-level sequence, the first-level sequence comprises a number of a sub-codebook, among the plurality of sub-codebooks, to which each element in an original sequence belongs, the second-level sequence comprises a position of the element in the sub-codebook to which the element belongs, and the original sequence is generated based on the overall codebook; and
obtaining the original sequence based on the codebook splitting information and the compressed sequence.

27. The method according to claim 26, wherein the compressed sequence is generated based on a to-be-transmitted sequence that is determined based on the first-level sequence and the second-level sequence and that corresponds to the original sequence.

28. The method according to claim 27, wherein the to-be-transmitted sequence comprises the first-level sequence and the second-level sequence, and the compressed sequence is generated in the following manners:
separately performing entropy encoding on the first-level sequence and the second-level sequence; or
performing entropy encoding on the first-level sequence and the second-level sequence together.

29. The method according to claim 28, wherein the to-be-transmitted sequence comprises at least one of the first-level sequence and the second-level sequence in a multi-layer sequence that are determined as not belonging to a to-be-hierarchized sequence, and the compressed sequence is generated in the following manners:
separately performing entropy encoding on the first-level sequence and the second-level sequence in the to-be-transmitted sequence; or
performing entropy encoding on the first-level sequence and the second-level sequence in the to-be-transmitted sequence together.

30. The method according to claim 29, wherein entropy encoding is separately performed on a plurality of sequences in the second-level sequence that belong to different sub-codebooks.

31. The method according to claim 27, wherein receiving the compressed sequence further comprises: receiving sequence information associated with the to-be-transmitted sequence, wherein
the sequence information comprises:
sequence length information, indicating a sequence length of the to-be-transmitted sequence.

32. The method according to claim 31, wherein when the to-be-transmitted sequence is obtained based on the multi-layer sequence, the sequence information further comprises:
sequence position information, indicating a layer at which a sequence in the to-be-transmitted sequence is located, a position of the sequence at the layer, and a position of a corresponding upper-layer sequence at an upper layer.

33. The method according to claim 31 or 32, wherein the sequence information further comprises:
sequence symbol indication information, indicating whether the sequence in the to-be-transmitted sequence is a first-level sequence or a second-level sequence.

34. The method according to any one of claims 31 to 33, wherein receiving the compressed sequence comprises: receiving the compressed sequence through a plurality of transmissions, wherein
one of the plurality of transmissions comprises:
receiving a part of the compressed sequence generated based on a part of the to-be-transmitted sequence, wherein
the part of the to-be-transmitted sequence is determined based on an amount of resources allocated for a current transmission.

35. The method according to claim 34, wherein the part of the to-be-transmitted sequence comprises: a part of the first-level sequence in an unsent part of the first-level sequence in the to-be-transmitted sequence and a part of the second-level sequence in an unsent part of the second-level sequence in the to-be-transmitted sequence, wherein
an element in the part of the first-level sequence corresponds to an element in the part of the second-level sequence; and
an amount of resources required for transmitting the part of the first-level sequence and the part of the second-level sequence is less than the amount of allocated resources.

36. The method according to claim 35, wherein receiving the part that is of the compressed sequence and that is obtained based on the part of the to-be-transmitted sequence further comprises: receiving sequence information associated with the part of the to-be-transmitted sequence, wherein
the sequence information associated with the part of the to-be-transmitted sequence comprises sequence symbol indication information indicating whether a sequence to which the part of the to-be-transmitted sequence belongs is a first-level sequence or a second-level sequence.

37. The method according to claim 36, wherein when the to-be-transmitted sequence is obtained based on the multi-layer sequence, the sequence information associated with the part of the to-be-transmitted sequence further comprises sequence position information of the sequence to which the part of the to-be-transmitted sequence belongs.

38. The method according to claim 34, wherein when a first-type sequence that is not transmitted exists:
in response to the amount of resources allocated for the current transmission being insufficient to transmit the first-type sequence that is not transmitted, the part of the to-be-transmitted sequence comprises at least one first-type sub-sequence selected from the first-type sequence that is not transmitted, wherein an amount of resources required for transmitting the selected at least one first-type sub-sequence is less than the amount of allocated resources; or
in response to the resources allocated for the current transmission being sufficient to transmit the first-type sequence that is not transmitted, the part of the to-be-transmitted sequence comprises the first-type sequence that is not transmitted, wherein
the first-type sequence comprises a first-level sequence or a second-level sequence.

39. The method according to claim 38, wherein the at least one first-type sub-sequence is selected based on a sub-codebook corresponding to the first-type sequence that has not been received.

40. The method according to claim 38, wherein when the amount of resources allocated for the current transmission is sufficient to send the unsent first-type sequence, in response to an amount of remaining available resources determined based on the amount of resources allocated for the current transmission and an amount of resources used to send the unsent first-type sequence being sufficient to send at least one second-type sub-sequence of an unsent second-type sequence, the part of the to-be-transmitted sequence further comprises the at least one second-type sub-sequence, wherein the second-type sequence is a sequence different from the first-type sequence in the first-level sequence and the second-level sequence.

41. The method according to claim 40, wherein the at least one second-type sub-sequence is determined based on a sub-codebook corresponding to the second-type sequence that has not been received, and receiving the part of the compressed sequence further comprises:
receiving a number of a sub-codebook corresponding to a second-type sub-sequence in the at least one second-type sub-sequence.

42. The method according to claim 34, wherein when the to-be-transmitted sequence is obtained based on the multi-layer sequence, the part of the to-be-transmitted sequence comprises:
based on an order of layers from high to low at which to-be-transmitted sequences that are not transmitted are located in the multi-layer sequence, sequences of a quantity of layers that are transmittable by using the amount of resources allocated for the current transmission.

43. The method according to claim 42, wherein receiving the part of the compressed sequence further comprises:
receiving sequence symbol indication information, sequence length information, and sequence position information of a sequence in the part of the to-be-transmitted sequence.

44. The method according to claim 42, wherein in response to an amount of remaining available resources determined based on the amount of resources allocated for the current transmission and an amount of resources used to send the sequences of the quantity of layers being sufficient to send at least one sub-sequence of a sequence at a layer lower than the sequences of the quantity of layers, the part of the to-be-transmitted sequence further comprises the at least one sub-sequence, wherein the at least one sub-sequence comprises at least one sub-sequence of a first-level sequence or a second-level sequence at the lower layer.

45. The method according to claim 42, wherein the at least one sub-sequence is determined based on a sub-codebook corresponding to the first-level sequence or the second-level sequence at the lower layer, and if the at least one sub-sequence is at least one sub-sequence of the second-level sequence, receiving the part of the compressed sequence further comprises:
receiving a number of a sub-codebook corresponding to a sub-sequence in the at least one sub-sequence and a position that is of a sequence to which the at least one sub-sequence belongs and that is at the lower layer.

46. The method according to claim 42, wherein obtaining the original sequence comprises:
performing entropy decoding on the compressed sequence to obtain a combined hierarchized sequence;
splitting each element in the combined hierarchized sequence into a group of a predetermined quantity of adjacent elements to obtain a hierarchized sequence; and
obtaining the original sequence based on the codebook splitting information and the hierarchized sequence.

47. The method according to any one of claims 26 to 46, wherein the codebook splitting information is obtained in one of the following manners:
pre-configured;
determined by an apparatus that receives the compressed sequence; or
received from an apparatus that sends the compressed sequence.

48. A first apparatus, comprising:
a module configured to perform the method according to any one of claims 1 to 25.

49. A second apparatus, comprising:
a module configured to perform the method according to any one of claims 26 to 47.

50. An electronic device, comprising a processor, configured to execute instructions stored in a memory, to cause the electronic device to perform the method according to any one of claims 1 to 25 or the method according to any one of claims 26 to 47.

51. A communication apparatus, comprising a processor and a communication interface, wherein the processor is configured to perform the method according to any one of claims 1 to 25 or the method according to any one of claims 26 to 47 using the communication interface.

52. A communication system, comprising at least one of a first apparatus and a second apparatus, wherein the first apparatus is configured to perform the method according to any one of claims 1 to 25, and the second apparatus is configured to perform the method according to any one of claims 26 to 47.

53. A computer-readable storage medium, wherein the computer-readable storage medium stores instructions; and when the instructions are executed by an electronic apparatus, the electronic apparatus is caused to perform the method according to any one of claims 1 to 25 or the method according to any one of claims 26 to 47.

54. A computer program product, wherein the computer program product comprises instructions; and when the instructions are executed by an electronic apparatus, the electronic apparatus is caused to perform the method according to any one of claims 1 to 25 or the method according to any one of claims 26 to 47.
